# FASCICULE DE BREVET EUROPEEN

(11) **EP 1 272 914 B1**
(45) Date de publication et mention de la délivrance du brevet: **20.11.2013**
(21) Numéro de dépôt: 01921505.2
(22) Date de dépôt: 06.04.2001
(51) Int. Cl.: G06F 17/50

(54) **PROCEDE ET INSTALLATION DE LOCALISATION OPTIMALE AUTOMATIQUE D'UNE OPERATION SUR UN CIRCUIT INTEGRE**
VERFAHREN UND VORRICHTUNG ZUR AUTOMATISCHEN OPTIMALEN LOKALISIERUNG EINER AKTION AUF EINER INTEGRIERTEN SCHALTUNG
METHOD AND DEVICE FOR AUTOMATIC OPTIMAL LOCATION OF AN OPERATION ON AN INTEGRATED CIRCUIT

(30) Priorité: 11.04.2000 FR 0004647
(43) Date de publication de la demande: 08.01.2003
(73) Titulaire: Centre National d'Etudes Spatiales (C.N.E.S.), 75039 Paris Cedex 01 (FR)
(72) Inventeur: DESPLATS, Romain, F-31400 Toulouse (FR); BENTEO, Bruno, F-31450 Pompertuzat (FR)
(74) Mandataire: Cabinet BARRE LAFORGUE & associés
(86) Numéro de dépôt international: PCT/FR2001/001048
(87) Numéro de publication internationale: WO 2001/077774

(56) Documents cités:
- US-A- 5 392 222
- US-A- 5 675 499
- KUNTZCH C ET AL: "LayDis - an Advanced Navigation System for Electron Beam Probing" MICROELECTRONIC ENGINEERING,NL,ELSEVIER PUBLISHERS BV., AMSTERDAM, vol. 31, no. 1, 1 février 1996 (1996-02-01), pages 355-362, XP004006647 ISSN: 0167-9317

## Description

L'invention concerne un procédé de localisation optimale automatique d'une opération d'intervention prédéterminée sur un circuit intégré comprenant au moins une étape -notamment une mesure, un test, une gravure, une coupure ou un dépôt- devant être appliquée en une zone localisée accessible du côté d'une face, dite face d'intervention du circuit intégré à au moins un élément fonctionnel électrique d'un circuit intégré -notamment choisi parmi une équipotentielle, un noeud, une jonction...-. L'invention s'étend à une installation dans laquelle ce procédé est mis en oeuvre.

Les circuits intégrés modernes tels que les circuits VLSI comprennent plusieurs couches physiques, à partir d'un substrat de silicium, définissant un schéma électrique comprenant de nombreux éléments fonctionnels électriques. Pour le test et/ou l'analyse et/ou la réparation des circuits intégrés, on utilise des installations comprenant des moyens de réception d'un circuit intégré, et des moyens d'intervention sur une face d'intervention du circuit intégré. Ces moyens d'intervention comprennent au moins un outil d'intervention adapté pour permettre l'exécution de chaque étape, et des moyens de positionnement précis de cet outil par rapport à la face d'intervention. Parmi les outils d'intervention classiquement utilisés, on peut citer notamment les faisceaux de particules focalisés (faisceau d'ions focalisé ou FIB, faisceau d'électrons...) avec lesquels la face d'intervention est en général la face supérieure du circuit (opposée au substrat) ; et les faisceaux laser pour lesquels la face d'intervention peut être la face inférieure du substrat.

Lorsqu'une opération d'intervention est envisagée, le problème qui se pose est celui du choix de la zone du circuit où chaque étape doit être exécutée. En effet, pour chaque étape, il existe en général de très nombreuses possibilités, toutes équivalentes au regard du schéma électrique théorique. Par exemple, il est possible de couper une branche d'équipotentielle en un point quelconque, d'effectuer une mesure électrique en un point quelconque d'une branche, ou d'effectuer un dépôt pour réaliser une connexion entre deux branches entre deux points quelconques de ces deux branches. Néanmoins, toutes ces possibilités ne sont pas équivalentes du point de vue pratique. En effet, tout d'abord, la zone d'intervention doit être accessible à l'outil d'intervention considéré, depuis la face d'intervention. En deuxième lieu, la difficulté de réalisation n'est pas toujours la même ; elle dépend en particulier de la densité des éléments du schéma dans la zone d'intervention considérée. En troisième lieu, la durée d'intervention peut varier considérablement. En particulier, cette durée dépend de la profondeur de la couche sur laquelle on intervient (distance par rapport à la face d'intervention) et de la difficulté d'accès de l'outil dans la zone d'intervention considérée. Pour un dépôt, la durée dépend aussi de la longueur de la piste déposée.

Or, on cherche à automatiser les opérations d'intervention (test et/ou analyse et/ou réparation) sur circuits intégrés, et à en réduire le risque d'échec, la difficulté et la durée qui sont des paramètres critiques essentiels dans le développement industriel des circuits intégrés.

Dans les installations d'intervention traditionnelles, on dispose de données de description topographique identifiant, dans chaque couche du circuit, des polygones formés chacun d'un matériau caractéristique (métal, polysilicium...) du circuit Ces données sont dites données d'implantation ou "layout". On dispose aussi de données représentatives du schéma électrique du circuit. Ces différentes données sont associées à des logiciels de visualisation permettant l'affichage de toute zone particulière du circuit.

US-5 675 499 décrit un procédé pour identifier de façon interactive et en temps réel le meilleur endroit où effectuer un test sur un circuit. Une liste de polygones est extraite pour chaque nom du réseau, c'est-à-dire pour chaque signal à partir des données de description topographiques et des données représentatives du schéma électrique. Les polygones d'un signal à tester sont tout d'abord séparés par segments de taille prédéterminée. Un score de test est ensuite calculé pour chaque segment en fonction de règles de test, et de poids qui sont affectés à chacune de ces règles. Le segment présentant le meilleur score est choisi, s'il existe, pour effectuer le test. S'il n'existe aucun segment présentant un score optimal, un score de coupure est calculé pour chaque segment en fonction de règles de coupure, et de poids qui sont affectés à chacune de ces règles de coupure. Une telle façon de procéder est lourde et complexe et ne permet pas en réalité d'optimiser automatiquement, rapidement et simplement une opération d'intervention susceptible de comprendre plusieurs étapes.

La publication KUNTZCH et al. "LayDis - an Advanced Navigation System for Electron Beam Probing" MICROELECTRONIC ENGINEERING, NL, ELSEVIER PUBLISHERS BV., AMSTERDAM, vol. 31, no. 1, 1 février 1996 (1996-02-01), pages 355-362, XP004006647 ISSN:0167-9317 présente le système de navigation avancée dénommée LayDis. Ce document indique qu'il a été proposé d'utiliser un logiciel tel que DRACULA pour créer une couche comprenant des régions de mesure optimales en appliquant des opérations de masquage au circuit intégré complet. Ce document indique également qu'une sélection automatique du point de mesure fondée sur des règles peut être implémentée. Mais ce document ne fournit pas de solution pratique efficace en ce sens.

US-5 392 222 décrit un procédé permettant de faciliter le positionnement de la fenêtre de visualisation de façon que les différentes pistes de matériau conducteur sur lesquelles on doit intervenir soient toutes situées dans la même fenêtre. Ce procédé permet de déterminer la fenêtre de visualisation optimale qui offre le maximum possible d'informations pour le diagnostic ou la réparation. La fenêtre de visualisation optimale permet ensuite à l'utilisateur humain de choisir aisément un endroit approprié pour effectuer l'opération d'intervention. Mais ce document ne permet pas d'optimiser automatiquement le lieu où chaque étape doit être effectuée. En particulier, il ne permet pas d'optimiser automatiquement, dans toute la longueur d'une équipotentielle du schéma électrique, le choix du polygone sur lequel une étape doit être effectuée.

L'intervention vise donc à pallier ces inconvénients en proposant un procédé et une installation permettant la localisation optimale automatique d'une opération d'intervention prédéterminée sur un circuit intégré.

L'invention vise aussi en particulier à optimiser la localisation de chaque étape de l'opération d'intervention en vue de permettre de faciliter l'exécution de l'opération d'intervention et/ou d'en optimiser la qualité de réalisation -notamment en évitant les erreurs- et/ou d'en minimiser la difficulté et la durée totale. Il est à noter que pour une opération d'intervention ayant plusieurs étapes, le fait de minimiser la durée totale de l'opération ne consiste pas nécessairement à minimiser la durée individuelle de chaque étape.

L'invention vise plus particulièrement à proposer un procédé et une installation déterminant automatiquement chaque polygone de départ à utiliser pour effectuer chaque étape de l'opération d'intervention en vue de permettre et de faciliter l'exécution de l'opération d'intervention, d'en optimiser la qualité de réalisation et/ou d'en minimiser la durée totale.

L'invention vise aussi à proposer un procédé pouvant être aisément implémenté sur une installation traditionnelle de test et/ou analyse et/ou réparation de circuits intégrés, de façon à obtenir une installation selon l'invention.

Pour ce faire, l'invention concerne un procédé de localisation optimale automatique d'une opération d'intervention sur un circuit intégré comportant plusieurs couches physiques définissant un schéma électrique à plusieurs éléments fonctionnels électriques -notamment choisis parmi des équipotentielles, des noeuds ou des jonctions-, cette opération d'intervention comprenant au moins une étape-notamment choisie parmi une mesure, un test, une gravure, une coupure ou un dépôt-appliquée à au moins .un élément du schéma électrique en une zone localisée accessible du côté d'une face, dite face d'intervention du circuit, ce procédé étant conforme à la revendication 1.

Ainsi, dans un procédé de localisation optimale automatique selon l'invention, le(les)polygone(s) de départ sur lequel(lesquels) chaque étape est effectuée, sont déterminés automatiquement par un calcul d'optimisation à partir de notes affectées à chacune des différentes options d'exécution possibles de chaque étape. On réalise ainsi un gain de temps considérable pour la réalisation de l'opération, l'utilisateur n'ayant en pratique qu'à identifier la nature des étapes à effectuer et le(les) élément(s) du circuit concernés. En outre, l'emploi d'un calcul d'optimisation objectif garantit que le choix final est bien le meilleur possible au regard des buts recherchés, ce qui se traduit ensuite par un risque d'échec moindre et une plus grande facilité de réalisation.

Selon les applications, les buis poursuivis, ou selon la nature des différentes opérations d'intervention, on peut choisir divers calculs d'optimisation.

Avantageusement et selon l'invention, le calcul d'optimisation est adapté pour faciliter l'exécution de l'opération d'exécution et/ou en optimiser la réalisation et/ou en minimiser la durée totale. En particulier, selon une caractéristique de l'invention, le calcul d'optimisation est adapté pour retenir, pour chaque étape, une option d'exécution optimale telle qu'une fonction multi-polynomiale -notamment le produit- des notes des options d'exécution des différentes étapes présente une valeur optimum, c'est-à-dire notamment une valeur minimum si les notes sont choisies décroissantes avec l'accessibilité, ou une valeur maximum si les notes sont choisies croissantes avec l'accessibilité.

Le procédé selon l'invention est aussi avantageusement caractérisé en ce qu'on calcule et on génère, pour chaque élément, des données de plusieurs séries de polygones accessibles avec, pour chaque série, un jeu de valeurs des paramètres αi, β et λ, en ce qu'on calcule et on affecte un coefficient d'accessibilité à chaque série à partir des valeurs des paramètres αi, β et λ, et en ce qu'on utilise ce coefficient d'accessibilité à titre de paramètre d'accessibilité lors du calcul de la note des options d'exécution de chaque étape effectuée sur cet élément.

Par ailleurs, avantageusement et selon l'invention, le procédé est aussi caractérisé en ce qu'on affecte à chaque polygone de départ possible un coefficient de profondeur qui varie en fonction de sa profondeur, et en ce qu'on calcule la note de chaque option d'exécution selon une fonction bipolynomiale du coefficient de profondeur et du coefficient d'accessibilité de chaque polygone de départ possible.

Avantageusement et selon l'invention, on utilise l'aire de la surface accessible réduite de chaque polygone de départ possible à titre de paramètre d'accessibilité.

En outre, avantageusement et selon l'invention, on utilise des paramètres d'accessibilité choisis selon la nature de l'étape à effectuer et/ou selon des caractéristiques d'au moins un outil d'intervention utilisé pour exécuter cette étape

Avantageusement et selon l'invention, lesdites données identifiant les polygones accessibles obtenus par l'étape d'extraction sont des données numériques selon un format compatible avec un logiciel d'affichage simultané d'au moins une partie des données d'implantation et des données du schéma électrique correspondant les unes aux autres -notamment le format CIF compatible avec le logiciel DRACULA ® commercialisé par la société CADENCE DESIGN SYSTEMS (Paris, France, http://www.cadence.com)-.

Avantageusement et selon l'invention, lorsque l'opération d'intervention consiste en une coupure d'une piste de matériau conducteur formant une équipotentielle du schéma électrique :
- on extrait, lors de l'étape d'extraction, les polygones accessibles d'une branche de la piste, dite branche réduite amont, s'étendant entre un point d'entrée prédéterminé et le premier noeud de dérivation rencontré selon un sens prédéterminé à l'aval du point d'entrée,
- on calcule et on affecte une note d'accessibilité à chaque polygone accessible de la branche réduite amont, qui constitue une option d'exécution pour effectuer la coupure,
- on détermine automatiquement l'option d'exécution optimale pour réaliser la coupure en choisissant parmi les polygones accessibles qui présentent une note d'accessibilité optimale, celui qui est le plus proche du point d'entrée.

De la sorte, on réalise la coupure le plus près possible du point d'entrée ce qui permet de conserver une longueur d'équipotentielle aussi grande que possible à l'aval de la coupure. Le point d'entrée et ledit sens prédéterminé peuvent être définis par un utilisateur (saisie) ou calculés par un système informatique de l'installation.

Avantageusement et selon l'invention, lorsque l'opération d'intervention consiste à réaliser un dépôt de matériau conducteur entre une piste, dite piste mère, de matériau conducteur formant une équipotentielle, dite équipotentielle mère, du schéma électrique, et une piste, dite piste fille, de matériau conducteur formant une équipotentielle, dite équipotentielle fille, du schéma électrique, chaque option d'exécution comprenant un polygone de départ possible, dit polygone mère (Pm), de la piste mère, et un polygone de départ possible, dit polygone fille (Pf), de la piste fille, on détermine automatiquement l'option d'exécution optimale à partir d'au moins un calcul de distance D(Pm, Pf) entre le polygone mère (Pm) et le polygone fille (Pf), en visant à minimiser cette distance.

Avantageusement et selon l'invention, on calcule la distance D(Pm, Pf) entre les polygones en considérant chaque polygone comme représenté par un segment de droite projeté dans un même plan parallèle à la face d'intervention.

Avantageusement et selon l'invention, on calcule la distance D(Pm, Pf) entre les polygones comme la plus petite valeur des quatre distances calculées entre leurs extrémités respectives et des distances entre chaque extrémité d'un de ces polygones et la projection orthogonale de cette extrémité, si elle existe, sur l'autre polygone.

Avantageusement et selon l'invention, on détermine l'option d'exécution optimale en optimisant la valeur d'une note d'exécution NEX de formule NEX=f(D(Pm, Pf), NACC(Pm), NACC(Pf)) où D(Pm, Pf) est la distance calculée entre les polygones mère (Pm) et fille (Pf) NACC(Pm), et NACC(Pf) sont des notes d'accessibilité des polygones mère (Pm) et, respectivement, fille (Pf) calculées de façon à être minimales pour les polygones de moindre profondeur et les plus accessibles, et f est une fonction multipolynomiale.

Avantageusement et selon l'invention, lorsque l'opération d'intervention consiste à réaliser une étape de coupure d'une piste, dite piste fille, de matériau conducteur formant une équipotentielle, dite équipotentielle fille du schéma électrique, et une étape de dépôt d'une piste de matériau conducteur entre une piste, dite piste mère, de matériau conducteur formant une équipotentielle, dite équipotentielle mère, du schéma électrique, et une portion résiduelle de la piste fille entre la coupure et un premier noeud de dérivation rencontré selon un sens prédéterminé à l'aval de la coupure,
- on extrait, lors de l'étape d'extraction, au moins tous les polygones accessibles de chaque piste mère et fille,
- on calcule et on affecte une note d'exécution à chaque option d'exécution de l'étape de dépôt en considérant tous les polygones accessibles de la piste mère et de la piste fille,
- on calcule et on affecte une note d'exécution à chaque option d'exécution de l'étape de coupure,
- on détermine automatiquement le meilleur compromis d'étape de coupure et d'étape de dépôt, en déterminant l'option d'exécution optimale de l'étape de dépôt correspondant à l'étape de coupure, en considérant, pour les options d'exécution de l'étape de dépôt, uniquement les polygones accessibles de la portion de la branche réduite amont de la piste fille s'étendant entre la coupure et le noeud topologique de dérivation.

L'invention s'étend aussi à une installation dotée de moyens de mise en oeuvre d'un procédé selon l'invention.

L'invention concerne donc une installation selon la revendication 16.

Une installation selon l'invention est adaptée pour la mise en oeuvre d'un procédé selon l'invention, et comprend notamment des moyens informatiques de calcul numérique adaptés pour traiter les données, et réaliser le calcul d'optimisation. Un procédé selon l'invention est donc mis en oeuvre dans et avec une installation selon l'invention.

L'invention concerne aussi un procédé et une installation caractérisés en combinaison par tout ou partie des caractéristiques mentionnées ci-dessus ou ci-après.

D'autres buts, caractéristiques et avantages de l'invention apparaîtront à la lecture de la description suivante qui se réfère aux figures annexées dans lesquelles :
- la figure 1 est un schéma d'un exemple d'installation FIB selon l'invention,
- la figure 2 est une vue schématique plus détaillée des moyens d'intervention et des moyens de réception d'un circuit intégré d'une installation FIB selon l'invention,
- la figure 3 est un exemple de fichier au format CIF dans lequel sont enregistrées les données représentatives de polygones accessibles d'un élément du schéma électrique d'un circuit intégré, pouvant être utilisé dans un procédé selon l'invention,
- la figure 4 est un schéma partiel montrant une piste mère et une piste fille pouvant faire l'objet d'une opération de coupure/dépôt avec un procédé selon l'invention,
- la figure 5 est un schéma partiel montrant deux polygones accessibles appartenant respectivement à une piste mère et une piste fille à relier par un dépôt, pour le calcul de leur distance dans un procédé selon l'invention,
- la figure 6 est un organigramme schématique d'un calcul d'optimisation d'un procédé selon l'invention dans le cas d'une opération de coupure/dépôt.

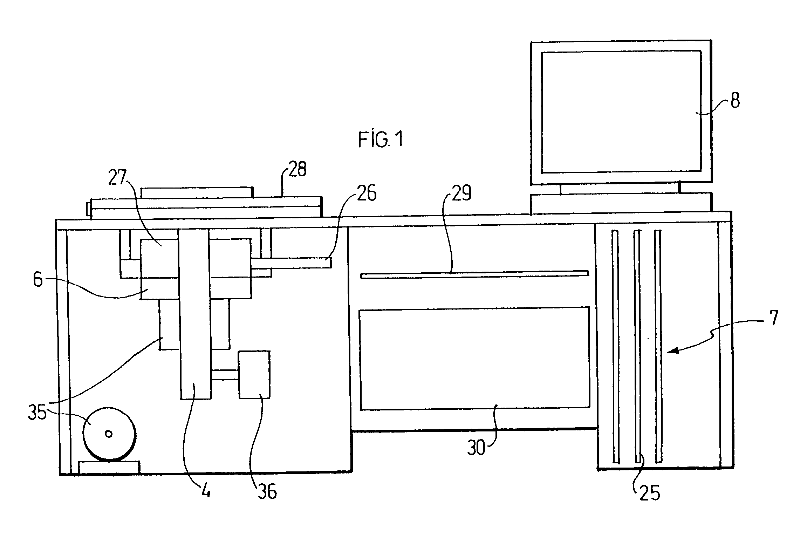

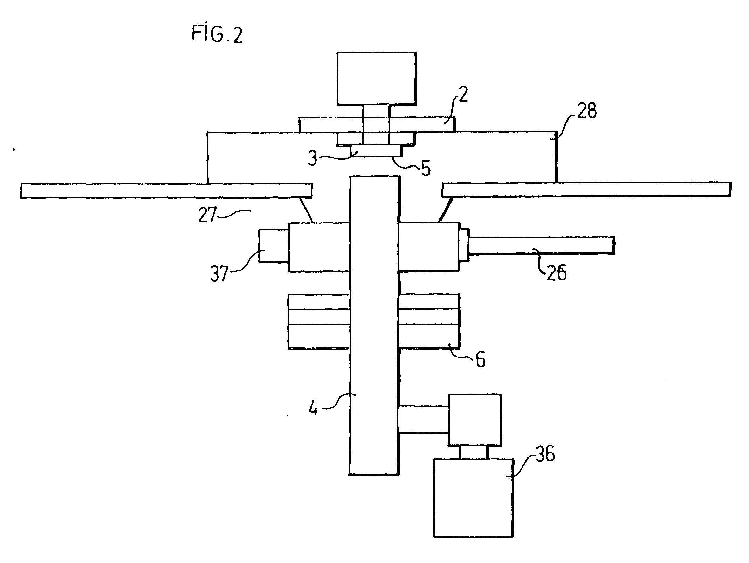

Une installation de test et/ou d'analyse et/ou de réparation de circuits intégrés est bien connue en soi et n'a pas à être décrite en détail, la connaissance de ses caractéristiques générales étant implicite. Il peut s'agir en particulier d'une installation à faisceau d'ions focalisé (FIB) telle que représentée figures 1 et 2, et/ou à faisceau d'électrons et/ou à faisceau laser telle qu'un système IDS Schlumberger (IDS P3X, IDS10000, IDS2000...). Par exemple, US-5 392 222 décrit de telles installations et la façon de les utiliser pour extraire des polygones accessibles. US-4 706 019, US-4 721 909 et US-5 140 164 décrivent plus en détail des systèmes IDS Schlumberger.

Une telle installation comprend un support 2 d'un circuit intégré 3 à traiter, et au moins un outil 4 d'intervention tel qu'un faisceau d'ions focalisé et/ou un faisceau d'électrons adapté pour pouvoir réaliser une opération d'intervention sur une face, dite face d'intervention 5 du circuit 3 placé sur le support 2. L'installation est aussi dotée de moyens 6 de positionnement précis de l'outil 4 sur la face d'intervention 5, permettant de déplacer et de maintenir l'outil 4 en XY, c'est-à-dire perpendiculairement à l'axe du faisceau, en tout point prédéterminé de cette face d'intervention 5.

Sur la figure 1, une installation FIB comprend une colonne FIB, un détecteur 26 de particules chargées, des moyens 37 d'injection de gaz appropriés et, le cas échéant, un canon à électrons, le tout étant monté sur un étage de positionnement XY 6, dans une chambre de scintillation 27, sous une chambre à vide 28 comprenant le support 2 du circuit 3. Elle comprend aussi un système informatique 7 comportant des moyens d'interface avec un utilisateur humain (écran 8, clavier, pointeur...), une unité centrale 25, des moyens 29 d'interface et de contrôle de la colonne FIB 4, des moyens 30 de contrôle de l'étage XY 6, des moyens 35 de pompage contrôlés par le système 7 pour faire le vide dans les chambres 27, 28, et une pompe à ions 36.

Dans le système informatique 7 peuvent être mémorisées des données d'implantation d'un circuit intégré 3 à traiter (dites "layout"), c'est-à-dire des données de description topographique identifiant, dans chaque couche du circuit 3, des polygones formés chacun d'un matériau caractéristique du circuit 3 -notamment un matériau conducteur électrique (métal), du polysilicium...- ; des données, dites de technologie, représentant les possibilités de connexion des différents polygones, les différents recouvrements entre pistes du circuit, les fichiers binaires correspondant, la nature des différents noeuds, jonctions..., et des options d'affichage graphique ; et des données représentatives du schéma électrique du circuit 3.

Les données de description topographiques sont en général enregistrées dans au moins un fichier LAYOUT au format CIF ("Caltech Interchange Format"), qui est un format texte de compréhension et d'utilisation faciles pour un utilisateur humain, ou au format GDSII (format binaire) ou autre.

Les données de technologie sont enregistrées dans un fichier TECHNOLOGY au format dit "ECAD" compatible avec un logiciel de conception assistée par ordinateur, et de compréhension et d'utilisation faciles pour un utilisateur humain.

Les données représentatives du schéma électrique sont enregistrées dans un fichier NETLIST au(x) format(s) dit(s) SPICE et/ou EDIF décrivant l'organisation fonctionnelle des noeuds électriques du circuit 3.

Le système informatique 7 permet l'affichage sur l'écran d'affichage 8 de fenêtres de visualisation des données d'implantation et des données du schéma électrique correspondant les unes aux autres.

Pour ce faire, un logiciel d'affichage tel que le logiciel DF2 ® de la société CADENCE DESIGN SYSTEMS, compatible avec le logiciel DRACULA ®, est implémenté dans le système informatique 7. Ce logiciel permet d'afficher une fenêtre LAYOUT présentant des données d'implantation du circuit 3, à partir du fichier LAYOUT et selon différentes options qui sont définies dans le fichier TECHNOLOGY, et, simultanément, une fenêtre NETLIST présentant des données du schéma électrique tout en établissant un lien entre les données de ces deux fenêtres LAYOUT et NETLIST. Ainsi, si l'opérateur sélectionne un nom de noeud dans la liste des noeuds dans la fenêtre NETLIST des données du schéma électrique, les polygones visibles d'une équipotentielle correspondant à ce noeud apparaîtront en blanc sur la fenêtre LAYOUT des données d'implantation. Réciproquement, si l'opérateur sélectionne une équipotentielle dans la fenêtre LAYOUT, le nom du noeud correspondant sera mis en lumière dans la fenêtre NETLIST.

Dans un procédé selon l'invention, on extrait tout d'abord pour chaque élément -notamment pour chaque équipotentielle- du circuit 3 sur lequel au moins une étape doit être effectuée, au moins une série de polygones accessibles depuis la face d'intervention 5 du circuit 3.

Le logiciel DRACULA ® peut être utilisé pour extraire les polygones accessibles, et générer un nouveau fichier de données d'implantation correspondant à ces polygones accessibles, dans un format compatible avec ce logiciel et avec les données du schéma électrique, notamment un format CIF ou GDSII.

Pour ce faire, on modifie les paramètres du fichier TECHNOLOGY, notamment en fonction des possibilités offertes par l'outil 4 utilisé et de la face d'intervention 5 de façon à définir des règles supprimant les portions de polygones masquées par des couches supérieures et à prendre en compte les imprécisions de l'outil 4 (conicité du faisceau (coefficients αi), largeur minimum d'une piste sur laquelle il peut intervenir (coefficient β), distance minimale entre pistes (coefficient λ).

Ainsi, le fichier TECHNOLOGY peut être adapté pour générer des données identifiant au moins une série de polygones accessibles qui satisfont aux conditions suivantes :
- ils présentent une surface, dite surface accessible réduite, correspondant à une surface non masquée du côté de la face d'intervention 5 par une couche supérieure de matériau de même nature, et dont la dimension dans chaque direction entre deux éléments supérieurs, est diminuée d'une valeur αi qui dépend de la profondeur de la couche du polygone et de la nature des moyens 4 d'intervention destinés à être utilisés sur cet élément,
- la dimension dans chaque direction de la surface accessible réduite est supérieure à une valeur seuil minimale β,
- ladite surface accessible réduite est distante de tous les polygones de matériau de même nature appartenant à un autre élément, d'une distance supérieure à une valeur λ prédéterminée.

La commande "RESIZE CMi by αi", où CMi sont les différentes couches du circuit 3, permet de prendre en compte la conicité du faisceau 4. L'instruction "FILTER" permet de prendre en compte le coefficient β de dimension minimale. Pour prendre en compte l'écartement minimal λ entre deux pistes distinctes, on considère comme invisibles les polygones ne satisfaisant pas cette condition.

En faisant varier les valeurs des coefficients αi, β et λ, on peut générer plusieurs séries de polygones accessibles, avec des critères d'accessibilité distincts d'une série à l'autre, par exemple une série de polygones très accessibles, une série de polygones moyennement accessibles, et une série de polygones peu accessibles.

Plusieurs méthodes peuvent être utilisées pour obtenir ces séries de données au format CIF ou GDSII. Le problème qui se pose est simplement de pouvoir récupérer les données binaires créées par le logiciel DRACULA ® et de les convertir au format CIF ou GDSII, en assurant un lien entre les numéros donnés aux éléments du circuit 3 par les données d'implantation, le logiciel DRACULA ® et les données du schéma électrique.

Dans une première variante, on peut utiliser la commande "GEN-XRF-RPT=YES" du logiciel DRACULA ® (version 4.7) qui génère directement des fichiers textes FMETi.DAT à partir des fichiers binaires METALi.DAT et POLY.DAT générés par le logiciel DRACULA ®. Cette même commande fournit aussi le fichier NETXREF.DAT au format texte dans lequel figurent les informations croisées faisant le lien entre le nom de chaque noeud du fichier NETLIST et le numéro de noeud dans ce fichier NETLIST, et un numéro affecté aux polygones de ce noeud par le logiciel DRACULA ®, et on peut alors obtenir, à partir d'un nom de noeud du fichier NETLIST, le numéro DRACULA ® correspondant aux polygones accessibles de ce noeud. Pour ce faire, on peut utiliser par exemple le programme CROSS-REF2 ci-joint.

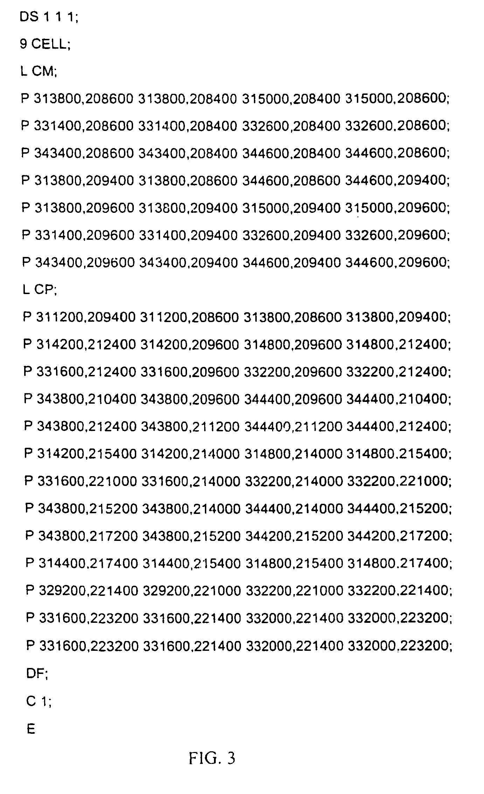

A partir de ces numéros DRACULA ®, on extrait les données correspondantes au format voulu et on les enregistre sur une mémoire du système informatique 7, par exemple grâce au programme NOEUD2.C ci-joint. On obtient pour chaque noeud, un fichier tel que le fichier au format CIF donné figure 3. Dans ce fichier, le champ L définit la couche des polygones (CMi couche métal ; CP : couche polysilicium). Chaque champ P définit un polygone par les coordonnées de ses quatre sommets.

Si nécessaire, on peut aussi transformer les polygones accessibles obtenus en quadrilatères si les polygones dans le fichier LAYOUT ne sont pas tous des quadrilatères.

Cette première variante permet ainsi d'extraire automatiquement les polygones accessibles, couche par couche, correspondant à un noeud (équipotentielle) dont on a spécifié le nom tel qu'il apparaît dans la fenêtre NETLIST.

Dans une deuxième variante, l'utilisateur peut sélectionner dans la fenêtre LAYOUT avec un pointeur (souris) du système informatique 7, l'équipotentielle sur laquelle il veut opérer. Il peut alors noter le numéro DRACULA ® qui s'affiche dans la fenêtre LAYOUT.

Si cela est souhaité, un programme peut aussi être utilisé pour extraire le numéro DRACULA ® à partir d'un fichier FMETi.DAT, et des coordonnées du point sélectionné par l'utilisateur. Ce même programme peut être utilisé si l'on ne dispose que des données d'implantation, et non celles du schéma électrique.

A partir du numéro DRACULA ®, on lance le programme NOEUD2.C ci-joint qui fournit le fichier CIF correspondant.

Cette deuxième variante est donc une variante graphique permettant d'obtenir le fichier CIF des polygones accessibles d'une équipotentielle.

Le même procédé réitéré pour toutes les équipotentielles sur lesquelles l'opération d'intervention doit être effectuée.

Ce procédé peut aussi être réitéré plusieurs fois, avec des fichiers TECHNOLOGY distincts, pour obtenir plusieurs séries de polygones accessibles, selon leur degré d'accessibilité -notamment avec des coefficients αi, β, λ différents-. Dans la première variante, chaque fichier TECHNOLOGY permet d'obtenir une série de fichiers binaires METALi.DAT et POLY.DAT à partir desquels on obtient les polygones accessibles sous forme de fichiers au format CIF. Dans la deuxième variante, le fichier TECHNOLOGY modifie l'image obtenue dans la fenêtre LAYOUT pour n'y illustrer que les polygones accessibles.

### OPERATION DE MESURE OU DE TEST :

Les polygones accessibles étant extraits, si l'opération d'intervention consiste en une simple étape de mesure ou de test sur un élément du circuit tel qu'une équipotentielle, une jonction... chaque polygone accessible est un polygone de départ possible sur lequel on peut réaliser la mesure, et est donc une option d'exécution de cette étape. Afin d'optimiser cette mesure, on affecte à chaque polygone accessible de l'élément une note d'accessibilité NACC.

Pour calculer cette note d'accessibilité NACC, on affecte à chaque polygone de départ possible un coefficient de profondeur COP qui est proportionnel à la profondeur de la couche dans laquelle il est situé par rapport à la face d'intervention 5. Ce coefficient COP peut être par exemple simplement formé du numéro de la couche dans laquelle il est situé, les couches étant numérotées dans l'ordre croissant, ou décroissant, dans l'ordre à partir de la face d'intervention 5. En outre, pour chaque série de polygones accessibles, selon la valeur des coefficients αi, β et λ, on affecte un même coefficient d'accessibilité CACC à chacun des polygones de la série. Ce coefficient d'accessibilité peut aussi être un simple nombre entier correspondant au numéro de la série, les séries étant numérotées dans l'ordre croissant, ou dans l'ordre décroissant, à partir de la série la plus facilement accessible par l'outil 4 du côté de la face d'intervention 5.

La note d'accessibilité NACC peut être calculée comme une fonction bipolynomiale des coefficients de profondeur COP et d'accessibilité CACC-notamment le produit de ces coefficients-.

Dans le cas d'une mesure, on peut utiliser une fonction plus complexe privilégiant le coefficient d'accessibilité CACC. En effet, la mesure est d'autant plus sûre qu'elle est effectuée sur un polygone éloigné des polygones des autres pistes de la même couche ou des couches supérieures.

Le système informatique 7 est programmé pour calculer cette note d'accessibilité pour tous les polygones de départ possibles et pour déterminer celui (ou ceux) qui présente(nt) la note d'accessibilité optimum, c'est-à-dire minimum, respectivement maximum, si les coefficients COP et CACC sont croissants, respectivement décroissants, à partir de la face d'intervention 5 et à partir de la série la plus facilement accessible.

Si plusieurs polygones de départ possibles présentent la note d'accessibilité optimum, on choisit par exemple celui dont l'aire est la plus grande ou celui qui correspond à un critère de forme préférentielle (angle...). Cette aire est calculée à partir des données des polygones accessibles précédemment extraits (figure 3), et correspond donc à l'aire de la surface accessible réduite de chaque polygone.

Dans une autre variante, il est possible d'incorporer directement la valeur de cette aire dans la fonction de calcul de la note d'accessibilité qui peut être notamment une fonction tri-polynomiale des coefficients COP et CACC et de l'aire des polygones.

On détermine ainsi automatiquement le polygone de départ optimal, correspondant à l'option d'exécution optimale de cette opération de mesure ou de test, et on positionne l'outil 4 d'intervention au moins sensiblement au centre du polygone pour effectuer l'étape de mesure correspondante.

Les coefficients αi, β, λ permettant d'obtenir les séries de polygones, sont déterminés selon la nature de l'outil 4 utilisé (sonde sans contact, sonde avec contact, laser...).

Cette opération de mesure ou de test peut être effectuée depuis la face supérieure, opposée au substrat, du circuit 3, qui fait office de face d'intervention 5, par exemple pour mesurer des courants ou potentiels d'une piste de matériau conducteur. Elle peut aussi à l'inverse être mise en oeuvre depuis la face inférieure du substrat du circuit 3, faisant office de face d'intervention 5, par exemple pour la mesure par laser sur des jonctions.

### OPERATION DE COUPURE :

Lors d'une opération de coupure d'une piste 10 formant une équipotentielle du schéma électrique de matériau conducteur, il est important de réaliser cette coupure 17 à l'amont de tout noeud 11 de dérivation topologique afin d'être certain de déconnecter de l'entrée IN de cette piste 10 toutes les branches 12, 13, 14, 15 et cellules situées en aval, c'est-à-dire jusqu'aux sorties OUT1, OUT2, OUT3 de l'équipotentielle 10.

En outre, la coupure 17 doit être effectuée aussi près que possible de l'entrée IN pour laisser le plus grand nombre de polygones de départ possibles à une opération ultérieure de dépôt ou autre.

En conséquence, après extraction de tous les polygones accessibles de la piste 10, lors de l'étape d'extraction, on extrait, parmi ceux-ci, les polygones accessibles appartenant à une branche de la piste 10, dite branche réduite amont 16, s'étendant entre un point d'entrée IN prédéterminé et le premier noeud 11 de dérivation topologique rencontré à l'aval du point d'entrée IN, selon un sens prédéterminé correspondant au sens de parcours du signal électrique dans la piste 10 (les termes amont et aval se référant à ce sens dans tout le texte).

Pour extraire les polygones accessibles de la branche amont réduite 16, on peut par exemple utiliser le programme ci-joint NOEUD-TOPOLOGIQUE 2.C.

Ce programme ordonne les polygones accessibles de la branche amont réduite 16 à partir du fichier CIF correspondant, et en partant du polygone contenant le point d'entrée IN sélectionné par l'utilisateur à l'aide du pointeur (souris). Les polygones sont tout d'abord triés couche par couche selon les coordonnées (xmin, ymin) de leur coin inférieur gauche.

On utilise ensuite les fichiers nVIA.DAT et nCONTACT.DAT des données d'implantation définissant, pour chaque noeud n du schéma électrique, les connexions entre les couches du circuit 3 pour ordonner dans l'ordre de leur succession du point de vue du cheminement du signal, les polygones accessibles de la branche amont réduite 16 depuis le point d'entrée IN jusqu'au premier noeud 11 topologique de dérivation rencontré à l'aval du point d'entrée IN.

Ceci étant fait, chaque polygone accessible de la branche amont réduite 16 correspond à une option d'exécution de l'étape de coupure à effectuer.

Pour déterminer automatiquement l'option d'exécution optimale, on affecte à chaque polygone de départ possible, une note d'accessibilité NACC calculée comme indiqué précédemment pour l'opération de mesure, en fonction d'un coefficient de profondeur COP et d'un coefficient d'accessibilité CACC.

On détermine alors le(les) polygone(s) ayant la note d'accessibilité optimale, et, parmi ceux-ci, on choisit, en tant qu'option d'exécution optimale, celui qui est le plus proche du point d'entrée IN, de façon à conserver une portion 16b aussi grande que possible entre la coupure 17 et le noeud 11 topologique de dérivation situé à l'aval pour une opération ultérieure.

Le programme ci-joint CUT.C est un exemple de programme permettant d'obtenir ce polygone de départ optimal dans le cas d'une seule série de polygones accessibles.

### OPERATION DE DEPOT :

L'opération d'intervention peut consister en une étape de dépôt de matériau conducteur entre une piste 20, dite piste mère, de matériau conducteur formant une équipotentielle, dite équipotentielle mère, du schéma électrique, et une piste 10, dite piste fille, de matériau conducteur formant une équipotentielle, dite équipotentielle fille 10, du schéma électrique.

Dans ce cas, on extrait au moins une série de polygones accessibles de chacune de ces pistes mère 20, et fille 10. Chaque option d'exécution de cette étape est alors définie par un polygone de départ possible, dit polygone mère Pm, choisi parmi une série de polygones accessibles de la piste mère 20, et un polygone de départ possible, dit polygone fille Pf, choisi parmi une série de polygones accessibles de la piste fille 10.

Pour optimiser une telle étape de dépôt, il convient tout d'abord, dans le cas d'un faisceau FIB, de prendre en compte le fait que plus la distance entre les polygones mère et fille à relier est longue, plus l'étape est périlleuse et coûteuse. Il convient donc de retenir l'option d'exécution dans laquelle les polygones mère Pm et fille Pf sont les plus proches l'un de l'autre. Pour ce faire, on effectue au moins un calcul de distance entre chaque couple de polygone mère Pm et de polygone fille Pf, en visant à minimiser cette distance.

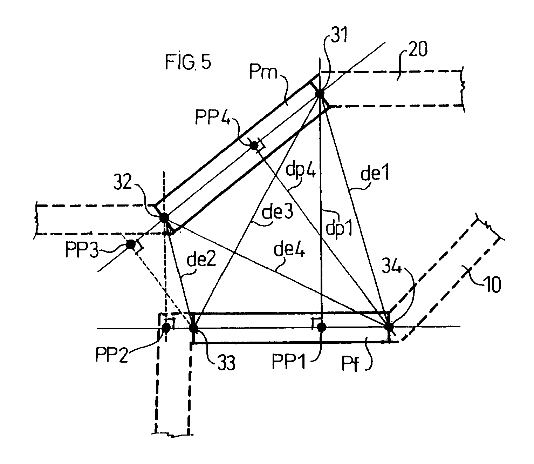

Ce calcul de distance peut être exécuté comme représenté figure 5. On considère chaque polygone comme représenté par un segment de droite projeté dans un même plan parallèle à la face d'intervention 5, même si les polygones appartiennent à des couches différentes. Ce segment de droite est déterminé par la ligne médiane longitudinale du polygone, calculée à partir des coordonnées de chaque coin du polygone.

On calcule alors la distance entre les polygones mère Pm et fille Pf comme la plus petite valeur des quatre distances de1, de2, de3, de4 calculées entre leurs extrémités 31 à 34 respectives, et des distances dp1, dp4 entre chaque extrémité 31 à 34 d'un de ces polygones Pm, Pf et la projection orthogonale PP1 à PP4 de cette extrémité 31, 34, si elle existe, sur l'autre polygone Pf, Pm. On calcule donc les quatre distances de1, de2, de3, de4 qui séparent deux à deux les extrémités 31, 32, 33, 34 des segments de droite représentant les polygones mère et fille. On calcule ensuite les coordonnées du point, dit point projeté PP1, PP2, PP3, PP4, qui est la projection orthogonale d'une extrémité 31, 32, 33, 34 d'un segment de droite d'un polygone sur la droite contenant le segment de droite de l'autre polygone. Sur la figure 5, PP1 est le point de projection de l'extrémité 31 du polygone mère Pm sur la droite contenant le polygone fille Pf ; PP2 est le point de projection de l'extrémité 32 du polygone fille Pf sur la droite contenant le polygone mère Pm ; PP3 est le point de projection de l'extrémité 33 du polygone mère Pm sur la droite contenant le polygone fille Pf ; PP4 est le point de projection de l'extrémité 34 du polygone fille Pf sur la droite contenant le polygone mère Pm.

Dans l'exemple de la figure 5, PP2 et PP3 étant néanmoins situés hors du segment de droite du polygone fille, respectivement du polygone mère, sont éliminés et ne servent pas pour le calcul de distance. On calcule donc les distances dp1 et dp4 entre chaque extrémité 31, 34 du segment de droite d'un polygone et sa projection orthogonale PP1, PP4, si elle existe, sur le segment de droite de l'autre polygone. Dans le cas général, il existe quatre telles distances. On calcule ensuite la distance D(Pm, Pf) entre les polygones Pm et Pf comme la valeur minimum des distances précédemment calculées, soit, dans l'exemple de la figure 5 :
D(Pm, Pf) = MIN (de1, de2, de3, de4, dp1, dp4)
D(Pm, Pf) = de2

Une fois cette distance calculée pour toutes les paires de polygones mère et fille, on examine s'il existe au moins une paire de polygones appartenant tous deux à la couche supérieure de la face d'intervention 5 et pour lesquels la distance D(Pm, Pf) est inférieure à une valeur seuil prédéterminée, par exemple 200µ. En effet, on sait qu'il est en général difficile d'effectuer des contacts avec des couches profondes. On privilégie donc un dépôt plus long si les polygones mère et fille appartiennent à la couche supérieure.

S'il existe plusieurs paires de polygones satisfaisant cette condition, on calcule une note, dite note d'exécution NEX, selon une formule :
NEX=f(D(Pm, Pf), NACC(Pm), NACC (Pf)), où NACC(Pm) est la note d'accessibilité du polygone mère et NACC (Pf) est la note d'accessibilité du polygone fille, et f est une fonction multipolynomiale de ces trois paramètres. On choisit alors l'option pour laquelle la note NEX est la meilleure.

Par exemple, dans le cas d'un faisceau FIB, on peut utiliser la formule NEX=D(Pm.Pf)xNACC(Pm)xNACC(Pf), et on choisit l'option en minimisant la note NEX. Dans le cas d'un faisceau laser, on affecte de préférence la distance D(Pm, Pf) d'un coefficient de pondération plus faible que les notes d'accessibilité NACC. En effet, dans ce cas, l'accessibilité est un critère plus important que la distance.

Les notes d'accessibilité sont calculées, comme décrit pour l'étape de mesure, avec les coefficients de profondeur COP et d'accessibilité CACC de chaque polygone, mais de façon à être minimales pour les polygones de moindre profondeur et les plus accessibles.

On choisit alors l'option d'exécution qui présente la note d'exécution NEX la plus faible.

Le programme ci-joint DEPOTOPT.C est un exemple de mise en oeuvre de ce calcul d'optimisation dans le cas d'une seule série de polygones accessibles pour chaque piste 10, 20, les notes d'accessibilité étant réduites aux coefficients de profondeur COP.

### OPERATION DE COUPURE/DEPOT :

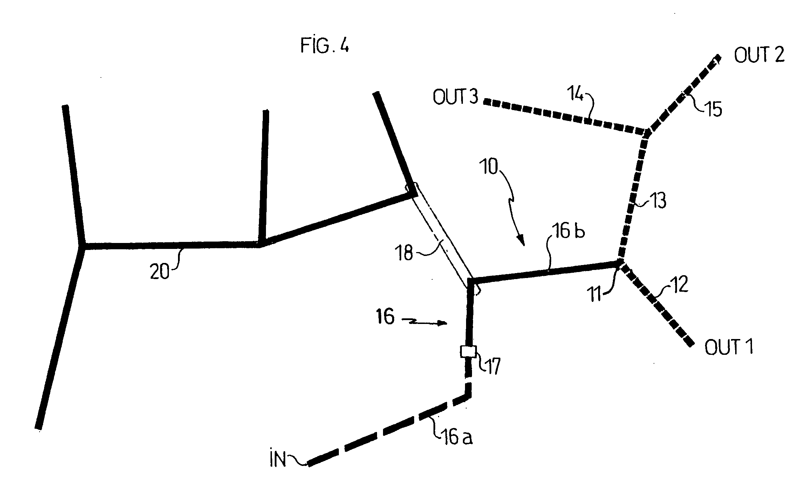

Une opération d'intervention couramment réalisée sur un circuit à réparer peut aussi consister à réaliser une étape de coupure 17 d'une piste, dite piste fille 10, de matériau conducteur formant une équipotentielle, dite équipotentielle fille du schéma électrique, et une étape de dépôt d'une piste de matériau conducteur 18 entre une piste, dite piste mère 20, de matériau conducteur formant une équipotentielle, dite équipotentielle mère, du schéma électrique, et une portion résiduelle 16b de la piste fille 10 entre la coupure 17 et un premier noeud 11 de dérivation rencontré selon un sens prédéterminé à l'aval de la coupure 17. Un exemple d'une telle opération d'intervention est représenté figure 4.

Il convient alors de déterminer quel est le meilleur compromis sur les deux étapes successives de coupure et de dépôt, à savoir une étape de coupure peu risquée (sur une couche peu profonde et un polygone très accessible) et un dépôt 18 le plus court possible et entre des polygones aussi peu profonds et aussi accessibles que possible.

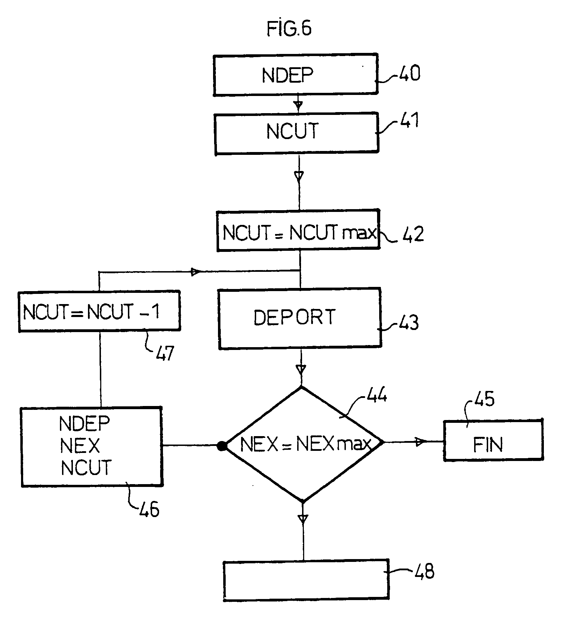

Pour ce faire, on procède avantageusement selon l'organigramme représenté figure 6.

Il est à noter que pour cette opération d'intervention soit correctement effectuée, deux conditions doivent être satisfaites :
- la coupure 17 doit être effectuée à l'amont de tout noeud 11 topologique de dérivation de la piste fille 10, c'est-à-dire sur la branche réduite amont 16;
- le dépôt 18 doit être relié à la portion 16b de la branche réduite amont 16 entre la coupure 17 et le premier noeud 11 topologique de dérivation situé à l'aval, et non sur la portion 16a s'étendant entre l'entrée IN et la coupure 17, de telle sorte que toutes les branches 12, 13, 14, 15 et cellules à l'aval soient reliées à la piste 20 mère.

Lors d'une étape initiale 40, on calcule et on affecte une note d'exécution NEX à toutes les options d'exécution de l'étape de dépôt entre les deux pistes mère 20 et fille 10, sans considération des deux conditions mentionnées ci-dessus, et ce, comme décrit ci-dessus en relation avec une opération de dépôt seul. On détermine alors l'option optimale de note d'exécution NEXmax et on ordonne les options d'exécution de l'étape de dépôt, par note d'exécution, en leur attribuant un numéro d'ordre NDEP.

Lors d'une étape subséquente 41, on ordonne toutes les options d'exécution de l'étape de coupure 17 sur la branche réduite amont 16 de la piste fille 10 selon leur note d'accessibilité, et pour les options de même note d'accessibilité, selon leur distance par rapport au point d'entrée IN, et on leur affecte un numéro d'ordre entrée NCUT, par exemple qui décroît à partir de l'option d'exécution optimale (meilleure note d'accessibilité et la plus proche du point d'entrée IN) jusqu'à celle qui est la moins bonne. Le numéro d'ordre NCUT croît donc avec la qualité des options d'exécution. Il est à noter que ce numéro d'ordre NCUT peut être considéré comme une note d'exécution de l'étape de coupure.

On sélectionne lors de l'étape 42 subséquente, l'option d'exécution de l'étape de coupure, de numéro d'ordre NCUTmax qui est la meilleure, indépendamment de l'étape de dépôt. Avec cette option, on recalcule, lors de l'étape 43, le dépôt optimal DEPOPT correspondant, comme décrit ci-dessus en relation avec une opération de dépôt seul, mais en prenant pour la piste fille 10 uniquement les polygones de la portion 16b de la branche réduite amont situés entre la coupure 17 et le noeud 11 topologique de dérivation.

On examine ensuite lors de l'étape 44 si la note d'exécution NEX de ce dépôt optimal DEPOPT est égale à NEXmax ou non, c'est-à-dire si ce dépôt optimal correspond à une option d'exécution optimale indépendamment de l'étape de coupure. Si tel est le cas, on termine le calcul d'optimisation lors de l'étape 45 puisque les options d'exécution des étapes de coupure et de dépôt qui sont optimales indépendamment sont aussi optimales conjointement. Si tel n'est pas le cas, on enregistre les trois valeurs NDEP, NEX et NCUT de ces options d'exécution (coupure, et dépôt optimal DEPOPT correspondant), lors de l'étape 46.

Lors de l'étape 47 suivante, on diminue d'une unité le numéro d'ordre NCUT de l'étape de coupure, de façon à sélectionner l'option d'exécution suivante de qualité immédiatement inférieure, et on réitère les étapes 43, 44, 46, et ce, jusqu'à avoir mémorisé les valeurs NDEP, NEX et NCUT pour toutes les options d'exécution de l'étape de coupure.

Une fois cette boucle terminée, on détermine lors de l'étape 48 parmi toutes les combinaisons NDEP, NEX et NCUT, celle qui correspond au compromis optimum. Pour ce faire, plusieurs variantes sont possibles. Dans une première variante, on peut choisir la combinaison présentant une note d'exécution NEX de valeur optimale NEXOPT (la plus grande) pour l'étape de dépôt. Dans une deuxième variante, on peut choisir une combinaison présentant un produit NEX x NCUT de plus grande valeur, et, s'il y a lieu, celle pour laquelle la note d'exécution NEX du dépôt est optimale. Plus généralement, on peut choisir une combinaison pour laquelle une fonction -notamment bi-polynomiale- prédéterminée de la note d'exécution NEX de l'étape de dépôt et de la note d'exécution (numéro d'ordre) NCUT de l'étape de coupure, prend une valeur optimale. S'il y a plusieurs telles combinaisons, on peut choisir celle pour laquelle la note d'exécution NEX du dépôt ou celle pour laquelle la note d'exécution NCUT de la coupure est la meilleure.

Le choix de cette variante peut être fait notamment selon la nature du circuit intégré 3 et/ou selon les caractéristiques de l'outil 4 (faisceau d'ions focalisé) utilisé.

Les fonctions d'un procédé selon l'invention sont réalisées par le système informatique 7 programmé à cet effet, et dans lequel sont mémorisées les données nécessaires correspondantes.

L'invention peut faire l'objet de nombreuses variantes par rapport aux modes de réalisation et variantes sus décrites. Par exemple, d'autres étapes peuvent être combinées et simultanément optimisées en tant qu'opération d'intervention ; d'autres calculs d'optimisation peuvent être retenus (par exemple à l'aide de fonctions multi-polynomiales de notes autres qu'un simple produit). L'invention s'applique aussi avec d'autres installations et d'autres logiciels que ceux décrits.

Les programmes sources donnés ci-après sont écrits en langage C et présentent à titre d'exemple une version simplifiée du procédé selon l'invention.

### ANNEXE

### PROGRAMME CROSS-REF2

### © 1999 CNES

Tous droits réservés. La reproduction intégrale ou partielle, permanente ou provisoire, par tout moyen ou sous toute forme, la traduction, l'adaptation, l'arrangement, l'exploitation à titre onéreux ou gratuit de ce programme sont strictement interdits sans l'autorisation écrite préalable du CNES.

Ce programme permet de trouver le numéro Dracula correspondant à un nom de Noeud de la Netlist.

```
 *
 Les paramètres d'entrée sont les suivants:
 *
 * - Le fichier Image.lis *
 * (ou Dracula affecte un numéro intermédiaire à chaque
 net) *
 * - Le fichier Netxref obtenu en traitant le fichier binaire
       6NXRF.DAT par l'utilitaire cadence printLVS.
       *
       * - Le nom du net dont on veut obtenir le numéro dracula.
       *
*
*Cette version fonctionne avec les fichiers IMAGE.LIS et
NETXREF tels qu'on les obtient par Dracula.
 */
 #include <stdio.h>
 #include <strings.h>
 FILE *input1;
 FILE *input2;
 char nom_net [50], name [50] ;
 int numero_net, number, number1, number2;
 int numero_dracula, repere1, repere2, i;
 main(argc,argv)
 int argc;
 char *argv [ ] ;
 { char ligne [120] ;
 if (argc!=4)
 {
 printf("Usage: ./cr Image.lis Netxref(obtenue de 6NXRF.DAT
 par printLVS) \"nom_net\" \n");
 exit (1) ;
 }
 if ((input1=fopen(argv[1],"r")) == 0)
 {
    printf("Erreur durant creation du fichier.\n\n");
    exit (1) ;
 }
 if ((input2=fopen(argv[2],"r")) == 0)
 {
    printf("Erreur durant création du fichier.\n\n");
    exit (1) ;
 }
 strcpy(nom_net,argv[3]);
 repere1=0;
 for (i=0;i<=4;i++)
 fgets(ligne,120, input1) ;
 while (!feof (input1))
     {
         ligne[0] = '\0';
         fgets(ligne,120, input1) ;
        sscanf(ligne,"%d %c %s", &number, name, name);
```

On se promène dans le fichier Image.LIS, et quand on trouve le numéro Netlist correspondant au nom Netlist, on sort de cette boucle et on mémorise le numéro Netlist dans numero_net. */

```
if (strcmp(name, nom_net) ==0)
      { numero_net=number;
          repere1=1;
          break;
          }
    }
    for (i=0;i<=8;i++)
    fgets(ligne,120, input2);
    repere2=0;
    while (!feof (input2))
     {
         ligne[0] = '\0';
         fgets(ligne,120, input2);
         sscanf(ligne,"%s %d %d",name, &number1, &number2);
```

On se promène dans le fichier NetXref, et quand on trouve le numéro de Net correspondant à numero_net, on sort de cette boucle et on mémorise le numéro dracula correspondant dans numero_dracula. */

```
if (numero_net==number1)
            { numero_dracula=number2;
               repere2=1;
                     break;
            }
    }
    if ((repere1==1) && (repere2==1))
    {
   printf("le Numero Dracula de l'équipotentielle %s est:
   \n", nom_net);
   printf("%d \n", numero_dracula);
    }
    /* S'il y a eu un problème lors de la recherche, on en indique
    l'origine. */
   else
       if (repere1==0)
       printf("Nom de net incorrect. \n");
       else
       printf("Probleme de compatibilite entre les Xref files.
       \n");
       fclose(input1);
       fclose(input2);
                  }
```

### PROGRAMMA NOEUD2.C

### © 1999 CNES

Tous droits réservés. La reproduction intégrale ou partielle, permanente ou provisoire, par tout moyen ou sous toute forme, la traduction, l'adaptation, l'arrangement, l'exploitation à titre onéreux ou gratuit de ce programme sont strictement interdits sans l'autorisation écrite préalable du CNES.

Ce programme permet de récupérer tous les polygones visibles d'une équipotentielle (dans un fichier au format CIF et à partir de son numéro Dracula). *

```
 * Les paramètres d'entrée sont les suivants:
 *
 * - le nombre de couches métalliques de la technologie à
 traiter *
 * - les fichiers métals traités par printrap de la couche
 métallique supérieure à la couche métallique inférieure. *
 * - le numéro Dracula de l'équipotentielle à extraire *
 *
 #include <stdio.h>
 #include <strings.h>
 FILE *input;
 FILE *result;
 unsigned int numéro, Xa, Ya, Xb, Yb, Xc, Xd, numero;
 unsigned int i,j,count;
 int nombre_couches;
 int k, l;
 char tableau[10] [10] ;
 main(argc,argv)
 int argc;
 char *argv[ ];
 { char ligne[120];
 if (argc!=(atoi(argv[1])+3))
 {
 printf("Usage: nombre_layer fichiers_layers(du metal_top au
 metal_inf) numero_dracula. \n");
 exit(1);
 }
 strcpy(tableau[0],"L CM;");
 for(l=1;l<=9;l++)
 {
 sprintf(tableau[l],"L CM%d;",l+1) ;
 }
 nombre_couches=atoi(argv[1]);
 On génère un fichier résultat de format CIF*/
 result=fopen("RES", "w");
 fprintf(result."(polygones correspondants au noeud %d);\n",
 atoi(argv[nombre_couches+2]));
 fprintf(result,"DS 1 1 1;\n");
 fprintf(result,"9 CELL;\n");
 for(k=2;k<nombre_couches+2;k++)
 {
  fprintf(result,"%s\n",tableau[nombre_couches-k+1]);
  if ((input=fopen(argv[k],"r")) == 0)
  {
  printf("Erreur durant creation du fichier.\n\n");
  exit(1) ;
  }
   while (!feof (input))
      { numero=0;
         ligne[0] = '\0';
         fgets(ligne,120, input);
         sscanf(ligne,"%d %d %d %d %d %d %d", &Yb, &Xb, &Ya,
         &Xa, &Xc, &Xd, &numero);
           if (numero==atoi(argv[nombre_couches+2]))
        { fprintf(result,"P %d %d %d %d %d %d %d %d;\n", Xa, Ya,
        Xb, Yb, Xc, Yb, Xd, Ya) ;
                   }
       }
       fclose(input);
       }
       fprintf(result,"DF;\n");
       fprintf(result,"C 1;\n");
       fprintf(result,"E\n");
       fclose(result);
       }
```

### PROGRAMME NOEUD-TOPOLOGIQUE2.C

### © 1999 CNES

Tous droits réservés. La reproduction intégrale ou partielle, permanente ou provisoire, par tout moyen ou sous toute forme, la traduction, l'adaptation, l'arrangement, l'exploitation à titre onéreux ou gratuit de ce programme sont strictement interdits sans l'autorisation écrite préalable du CNES.

Ce programme permet de trouver le premier noeud topologique d'une équipotentielle, à partir des coordonnées d'un pt (IN), on effectue la recherche en classant 1 à 1 les polygones

```
 *
 * Les 5 paramètres d'entrée sont les suivants: *
 * - le Fichier CIF de l'équipotentielle complète *
 * - la coordonnée X (en microns) *
 * - la coordonnée Y (en microns) *
 * - l'échelle du Layout *
 * - le nombre de couches de la techno *
 * Ce programme nous permet de récupérer classes par ordre
 d'apparition *
 * dans l'équipotentielle tous les polygones du cif.
 * Si un polygone possède plus d'un polygone suivant, c'est
 qu'on est sur un noeud topologique. *
 *
 *
 *
 #include <stdio.h>
 #include <strings.h>
 #include <math.h>
 #define res 1000
 FILE *input;
 float Xa, Ya, Xb, Yb, Xc, Yc, Xd, Yd, X, Y, x, y;
 int numéro, numero_IN,numero_present,numero_suivant,
 noeud_topologique;
 int nombre_couches;
 int nombre_de_polygones_restants;
 float échelle;
 int i, j, k, nombres_polygones;
 char ligne[120];
 int *tableau_x;
 int *tableau_y;
 struct ma_memoire {
           float xmin;
              float ymin;
              float xmax;
              float ymax;
              int numero_polygone;
              int layer;
                  };
                  struct ma_memoire tableau_polygones[res];
                  void init_tableau_polygones ()
                  /*************************************************************
                  ***********************************
                  * Cette procédure initialise à 0 la structure
                  tableau_polygones. *
                  * On stocke dans cette mémoire toutes les informations
                  concernant chaque polygone du CIF. *
                  * *
                  **************************************************************
                  ***********************************/
                  {int i;
 for (i=0;i<res;i++)
     {
     tableau_polygones [i] .xmin=0;
     tableau_polygones [i] .ymin=0;
     tableau_polygones [i] .xmax=0;
     tableau_polygones [i] .ymax=0;
     tableau_polygones [i] .numero_polygone=0;
     tableau_polygones [i] .layer=0;
     }
     }
     void remplissage_tableau()
     /*************************************************************
     ***********************************
     * Cette procédure génère le tableau indispensable à ce
     programme: *
     * Ce tableau est un tableau de structure qui contient toute
     l'information concernant un polygone, c'est a dire coordonnées
     minimales et maximales, numéro (c'est nous qui attribuons
     arbitrairement un numéro d'identité a chaque polygone
     rencontré dans le fichier CIF), et enfin la couche à laquelle
     il appartient. *
     * Pour cela on lit simplement le fichier cif. *
     **************************************************************
     ***********************************/
     {int 1, i, j, deja;
 char kiki;
 i=0;
     fgets(ligne, 120, input);
     fgets(ligne, 120, input);
     fgets(ligne, 120, input);
     fgets(ligne, 120, input);
     fgets(ligne, 120, input);
     sscanf(ligne, "%c %f %f %f %f %f %f %f %f ", &kiki, &Xa,
     &Ya, &Xb, &Yb,
     &Xc, &Yc, &Xd, &Yd);
     for(1=0;1<=nombre_couches-1;1++)
     {
    while (kiki=='P')
     { deja=0;
       for(j=0; j<=i; j++)
        if ((Xb*echelle>=tableau_polygones [j] .xmin) &&
              (Yb*echelle>=tableau_polygones [j] .ymin) &&
              (Xd*echelle<=tableau_polygones [j] .xmax) &&
              (Yd*echelle<=tableau_polygones [j] .ymax))
             deja=1;
       if (deja==0)
       {
       tableau_polygones [i] .xmin=Xb*echelle;
       tableau_polygones [i] .ymin=Yb*echelle;
        tableau_polygones [i] .xmax=Xd*echelle;
       tableau_polygones [i] .ymax=Yd*echelle;
       tableau_polygones [i] .numero_polygone=i+1;
       tableau_polygones [i] .layer=1;
       i=i+1;
       }
    fgets(ligne, 120, input);
    sscanf(ligne, "%c %f %f %f %f %f %f %f %f ", &kiki, &Xa,
    &Ya, &Xb, &Yb,
    &Xc, &Yc, &Xd, &Yd);
          }
    fgets(ligne, 120, input);
    sscanf(ligne, "%c %f %f %f %f %f %f %f %f ", &kiki, &Xa,
    &Ya, &Xb, &Yb,
    &Xc, &Yc, &Xd, &Yd);
        }
        nombres_polygones=i;
        }
 void numero_du_polygone_IN ()
 /*************************************************************
 ***********************************
 *Cette procédure retrouve le numéro (celui que l'on a attribue
 dans remplissage_tableau) correspondant au polygone d'entrée
 de l'équipo-tentielle ; c'est à partir de ce premier numéro
 que l'on pourra lancer la recherche de suivants.
 * *
 **************************************************************
 ***********************************/
 {int i;
 numero_IN=0;
 for (i=0;i<=nombres_polygones-1;i++)
 {
    if ((X>=tableau_polygones[i] .xmin) &&
    (X<=tableau_polygones [i] .xmax)
         && (Y>=tableau_polygones [i] .ymin) &&
         (Y<=tableau_polygones [i] .ymax))
     numero_IN=tableau_polygones [i] .numero_polygone;
     }
     if(numero_IN==0)
     {
     printf("Ce point ne correspond pas a un polygone!!!\n");
     exit();
     }
     void classement (rep,nombres_polygones)
     /*************************************************************
     ***********************************
     * Cette procédure nous permet d'effectuer un classement selon
     les x ou les y des polygones du cif. On transfère dans
     tableau_entree, qui est lui même un tableau de structures
     * (valeur, numéro) tous les xmin et xmax, associés à leur
     numéro de polygone, dans le cas ou on effectue un classement
     selon les x, ou tous les ymin et ymax, associés à leur numéro
     de polygone, dans le cas ou l'on effectue un classement
     suivant les y.
     * le choix de classer suivant les x, ou suivant les y est
     donné par la valeur de rep: *
     * rep=1 on classe suivant les x
     *
     * rep=0 on classe suivant les y
     *
     *
     *Les résultats sont exprimés sous la forme de tableaux
     d'entiers tableau_x et tableau_y *
     *Ces tableaux contiennent le numéro polygone associé
     correspondant au classement par ordre croissant de l'ensemble
     des xmin et xmax ou ymin et ymax. *
     **************************************************************
     ***********************************/
     int rep;
     int nombres_polygones;
     {
 int i, j, k, repere;
 float min;
 struct entree {
              float valeur;
              int numero;
              };
              struct entree *tableau_entree;
              tableau_entree=(struct entree*)calloc (2*nombres_polygones-
              1, size of (struct entrée));
 for (i=0;i<=nombres_polygones-1;i++)
 { if (rep==1)
         {
    tableau_entree[2*i].valeur=tableau_polygones[i].xmin;
    tableau_entree[2*i].numero=tableau_polygones[i].numero_poly
    gone;
    tableau_entree[2*i+1].valeur=tableau_polygones[i].xmax;
    tableau_entree[2*i+1].numero=tableau_polygones[i].numero_po
    lygone;
         }
     else
     {
    tableau_entree[2*i].valeur=tableau_polygones[i].ymin;
   tableau_entree[2*i].numero=tableau_polygones[i].numero_poly
   gone;
   tableau_entree[2*i+1].valeur=tableau_polygones[i].ymax;
   tableau_entree[2*i+1].numero=tableau_polygones[i].numero_po
   lygone;
         }
         }
     for (j=0;j<=2*nombres_polygones-1;j++)
     {
     min=tableau_entree[0].valeur;
     repere=0;
  for (i=1;i<=2*nombres_polygones-1-j;i++)
    {
     if (tableau_entree[i].valeur<=min)
         {
        min=tableau_entree[i].valeur;
        repere=i;
         }
    }
    if (rep==1)
    tableau_x[j]=tableau_entree[repere].numero;
    else
    tableau_y[j]=tableau_entree[repere].numero;
  for (k=repere;k<2*nombres_polygones;k++)
  {
  tableau_entree[k].valeur=tableau_entree[k+1].valeur;
  tableau_entree[k].numero=tableau_entree[k+1].numéro;
  }
  }
  free(tableau_entree);
  }
  void recherche_polygone_suivant(numero_present)
  /*************************************************************
  ***********************************
  * Cette procédure recherche le polygone suivant à l'aide de
  tableau_x et tableau_y. *
  **************************************************************
  ***********************************/
  int numero_present;
  {int i,j, suivant1, suivant2, deuxieme_fois;
  int repx1, repx2, repy1, repy2;
  deuxieme_fois=0;
  for (i=0;1<=2*nombres
_polygones-1;i++)
  {
    if (numero_present==tableau_x[i])
       {
        if (deuxieme_fois==1)
        repx2=i;
     else
       {
        repx1=i;
            deuxieme_fois=1;
           }
       }
       deuxieme_fois=0;
 for (i=0;i<=2*nombres_polygones-1;i++)
  {
   if (numero_present==tableau_y[i])
       {
        if (deuxieme_fois==1)
        repy2=i;
     else
       {
        repy1=i;
            deuxieme_fois=1;
           }
       }
  }
  suivant1=0;
  suivant2=0;
  noeud_topologique=0;
 for (i=repx1+1;i<=repx2-1;i++)
   {
     for (j=repy1+1;j<=repy2-1;j++)
          {
      if ((suivant1==0) && (tableau_x[i]==tableau_y[j]))
              suivant1=tableau_x[i];
      else if ((suivant1!=0) && (tableau_x[i]==tableau_y[j]))
             suivant2=tableau_x[i];
      }
     }
     numero_suivant=suivant1;
     if (suivant2!=0)
 noeud_topologique=1;
 }
 void troncature(numero)
 /*************************************************************
 ***********************************
 * Cette procédure élimine le polygone de numéro numéro, des
 listes tableau_x et tableau_y. *
 **************************************************************
 ***********************************/
 int numero;
 {
 int i;
 int repx1, repx2, repy1, repy2;
 int deuxieme_fois;
 deuxieme_fois=0;
 for (i=0;i<=2*nombres_polygones-1;i++)
   {
    if (numero==tableau_x[i])
        {
         if (deuxieme_fois==1)
         repx2=i;
     else
        {
         repx1=i;
             deuxieme_fois=1;
           }
   }
   deuxieme_fois=0;
   for (i=0;i<=2*nombres_polygones-1;i++)
   {
    if (numero==tableau_y[i])
        {
         if (deuxieme_fois==1)
         repy2=i;
     else
        {
         repy1=i;
            deuxieme_fois=1;
           }
   }
   for (i=repx1;i<=2*nombres_polygones-1;i++)
 tableau_x[i]=tableau_x[i+1];
 for (i=repx2-1;i<=2*nombres_polygones-1;i++)
 tableau_x[i]=tableau_x[i+1];
 for (i=repy1;i<=2*nombres_polygones-1;i++)
 tableau_y[i]=tableau_y[i+1];
 for (i=repy2-1;i<=2*nombres_polygones-1;i++)
 tableau_y[i]=tableau_y[i+1];
 }
 main(argc,argv)
 int argc;
 char *argv[];
 {
 if (argc!=6)
 {
 printf("usage: ./prog Fichier.cif X Y echelle nombre_couches
 \n");
 exit(1);
 }
 init_tableau_polygones();
 X=atof(argv[2]);
 Y=atof(argv[3]);
 echelle=atof(argv[4]);
 nombre_couches=atoi(argv[5]);
 if ((input=fopen(argv[1],"r")) == 0)
  {
    printf("Erreur durant creation du fichier.\n\n");
    exit(1);
  }
 remplissage_tableau();
 nombre_de_polygones_restants=nombres_polygones;
 tableau_x=(int*)calloc(2*nombres_polygones,size of (int));
 tableau_y=(int*)calloc(2*nombres_polygones,size of (int));
 classement(1,nombres_polygones);
 classement(0,nombres_polygones);
 numero_du_polygone_IN();
 numero_present=numero_IN;
 printf("numero IN:%d\n",numero_IN);
 printf("poussin\n");
 /* for (k=0;k<=nombres_polygones-1;k++)
 printf("xmin=%f, ymin=%f,xmax=%f, ymax=%f, numero=%d,
 layer=%d \n",
 .tableau_polygones[k].xmin,tableau_polygones[k].ymin,.
 .tableau_polygones[k].xmax,tableau_polygones[k].ymax,tableau_p
 olygones[k].numero_polygone, tableau_polygones[k].layer);
 printf("\n"); */
 printf("poussin\n");
 do {
 recherche_polygone_suivant(numero_present);
 printf("poly suivant:%d, xmin:%f, ymin:%f, xmax:%f, ymax:%f,
 layer:%d \n", numero_suivant,
 tableau_polygones[numero_suivant-
 1].xmin,tableau_polygones[numero_suivant-1].
 ymin,tableau_polygones[numero_suivant-1].xmax,
 tableau_polygones[numero_suivant-1].ymax,
 .tableau_polygones[numero_suivant-1].layer);
 troncature(numero_present);
 numero_present=numero_suivant;
    }
    .while ((noeud_topologique!=1) && (numero_suivant!=0));
 printf("nombres poly:%d \n", nombres_polygones);
 fclose(input);
 free(tableau_x);
 free(tableau_y);
                   }
```

### PROGRAMME CUT-C

### © 1999 CNES

Tous droits réservés. La reproduction intégrale ou partielle, permanente ou provisoire, par tout moyen ou sous toute forme, la traduction, l'adaptation, l'arrangement, l'exploitation à titre onéreux ou gratuit de ce programme sont strictement interdits sans l'autorisation écrite préalable du CNES.

Ce programme permet trouver le cut optimal pour une équipotentielle subdivise, à partir des coordonnées d'un pt (IN) *

```
 * *
 *Les 5 paramètres d'entrée sont les suivants:
 *
 * - le fichier CIF de l'équipotentielle *
 * - la coordonnée X (en microns) *
 * - la coordonnée Y (en microns) *
 * - l'échelle du Layout *
 * - le nombre de couches de la technologie *
 * *
 #include <stdio.h>
 #include <strings.h>
 #include <math.h>
 #define res 20
 FILE *input;
 FILE *result;
 float D, note;
 float Xa, Ya, Xb, Yb, Xc, Yc, Xd, Yd, X, Y, x, y;
 unsigned int numero;
 char kiki;
 int repere, nombre_couches;
 float échelle;
 int i,j, 1;
 int table[10];
 char ligne[120];
 struct ma_memoire {
             float x;
             float y;
             float mark;
             int 1;
                 };
                 struct ma_memoire resultats[res];
                 void init_resultats()
                 {int i;
                 for (i=0;i<res;i++)
    {
    résultats[i].x=0;
    resultats[i].y=0;
    resultats[i].mark=100000000;
    résultats[i].1=0;
    }
    }
    void mise_a_jour()
    {
    i=res-1;
    while ((note<resultats[i].mark) && (i>=0))
    {
    i=i-1;
    }
     printf("note %f ", note);
     printf("note_tableau%f ", resultats[i].mark); */
     if (i<res-1)
 {
 for (j=res-1;j>i;j--)
     {
     résultats[j]=resultats[j-1];
     }
 résultats[i+1].x=x;
 résultats[i+1].y=y;
 résultats[i+1].mark=note;
 résultats[i+1].1=1;
 }
 }
 main(argc,argv)
 int argc;
 char *argv[];
 {
 if (argc!=6)
 {
 printf("usage: ./cut Fichier.cif X Y echelle nombre_couches
 \n");
 exit(1);
 }
 table[0]=1;
 for (i=1;i<=10;i++)
 table [1]=2*table[i-1];
 init_resultats();
 X=atof(argv[2]);
 Y=atof(argv[3]);
 echelle=atof(argv[4]);
 nombre_couches=atoi(argv[5]);
 if ((input=fopen(argv[1],"r")) == 0)
    printf("Erreur durant creation du fichier.\n\n");
    exit(1);
 }
 result=fopen("notes_cut.txt", "w");
     fgets(ligne, 120, input);
     fgets(ligne, 120, input);
     fgets(ligne, 120, input);
     fgets(ligne, 120, input);
     fgets(ligne, 120, input); &kiki, &Xa,
     sscanf(ligne, "%c %f %f %f %f %f %f %f %f ", &kiki, &Xa,
     &Ya, &Xb, &Yb,
      &Xc, &Yc, &Xd, &Yd);
      for (1=0;1<=nombre_couches-1;l++)
     {
    while (kiki=='P')
     {
       x=(Xa+Xc)/2*echelle;
       y=(Ya+Yc)/2*echelle;
    D=hypot((double)(x-X), (double)(y-Y));
    note=D*table[l];
    mise_a_jour();
     fprintf(result, "N:%lf x:%f y:%f layer:%d \n",note,x,y,l);
     fgets(ligne, 120, input);
    sscanf(ligne, "%c %f %f %f %f %f %f %f %f ", &kiki, &Xa,
    &Ya, &Xb, &Yb,
    &Xc, &Yc, &Xd, &Yd);
           }
    fgets(ligne, 120, input);
    sscanf(ligne, "%c %f %f %f %f %f %f %f %f ", &kiki, &Xa,
    &Ya, &Xb, &Yb,
    &Xc, &Yc, &Xd, &Yd);
        }
        for (i=0;i<=res-1;i++)
        printf("N%d %1f, x %f, y %f, %d \n", i , resultats[i].mark,
        resultats[i].x, resultats[i].y, resultats[i].1);
        fclose(input);
        fclose(result);
        }
```

### PROGRAMME DEPOTOPT.C

### © 1999 CNES

Tous droits réservés. La reproduction intégrale ou partielle, permanente ou provisoire, par tout moyen ou sous toute forme, la traduction, l'adaptation, l'arrangement, l'exploitation à titre onéreux ou gratuit de ce programme sont strictement interdits sans l'autorisation écrite préalable du CNES.

Ce programme permet de trouver un dépôt optimal entre deux équipotentielles mère et fille. *

Les 4 paramètres d'entrée sont les suivants:

```
- le nombre de couches métalliques de la technologie *
 * - le Layout de l'équipotentielle mère *
 * - le Layout de l'équipotentielle fille *
 * tous deux en format CIF *
 * - l'échelle du CIF d'entrée *
 * *
 * *
 * L'utilisation est la suivante: Les deux paramètres d'entrée
 sont les layouts des deux équipotentielles en format cif,
 obtenues à l'aide du programme Noeuds2.c. *
 * Ce programme affecte une note pour chaque dépôt, qui est
 proportionnelle à la distance pondérée par un coefficient de
 profondeur. *
 * On instancie ces coefs de profondeur dans la variable table.
 *
 * Enfin, toutes les notes sont stockées dans le fichier
 TABLEAU: *
 * -la note stockée sur la ieme ligne et la jeme colonne
 correspond au *
 * ieme polygone de l'équipotentielle mère et au jeme polygone
 de l'équipotentielle fille */
 #include <stdio.h>
 #include <math.h>
 FILE *input1;
 FILE *input2;
 FILE *result;
 double Xma, Yma, Xmb, Ymb, Xmc, Ymc, Xmd, Ymd, Xfa, Yfa, Xfb,
 Yfb, Xfc, Yfc, Xfd, Yfd;
 double Xm1, Ym1, Xf1, Yf1, Xm2, Ym2, Xf2, Yf2, Xm, Ym, Xf,
 Yf;
 double L11, L12, L21, L22;
 double note;
 double D;
 int coef;
 int i, j, k, l;
 int table [10];
 float echelle;
 char kikim, kikif;
 char ligne[120];
 struct ma_memoire {
             double X1;
             double Y1;
             double X2;
             double Y2;
             double mark;
             int lm;
             int lf;
                 };
                 struct ma_memoire resultats[20];
                 /*************************************************************
                 *******************
                 Cette structure nous permettra de stocker les 20 meilleurs
                 dépôts calculés *
                 **************************************************************
                 *******************/
                 int nombre_couches;
                 /*************************************************************
                 *******************
                 * *
                 * *
                 * *
                 **************************************************************
                 *******************/
                 /*************************************************************
                 *******************
                 *Cette procédure permet d'initialiser le tableau de résultats*
                 **************************************************************
                 *******************/
                 void init_resultats()
                 {
                 for (i=0;i<=19;i++)
    {
    resultats[i].X1=0;
    resultats[i].Y1=0;
    resultats[i].X2=0;
    resultats[i].Y2=0;
    resultats[i].mark=100000000;
    resultats[i].lm=0;
    resultats[i].lf=0;
    } }
    /*************************************************************
    *******************
    * On calcule ici la longueur des 4 hauteurs correspondants à
    un couple de polygones, c'est à dire les projections
    orthogonales des milieux des petits côtés sur l'axe principal
    du polygone opposé. *
    **************************************************************
    *******************/
    void calcul_hauteur (X1, Y1, X2, Y2, X, Y, distance, x, y)
    double X1, Y1, X2, Y2, X, Y;
    double *distance;
    double *x;
    double *y;
    {
    double a, b, Xtest, Ytest, distance_test, demi_segment,a1,b1;
    Xtest=(X1+X2)/2;
    Ytest=(Y1+Y2)/2;
    demi_segment=(hypot((X1-X2), (Y1-Y2)))/2;
    if (X1==X2)
 { distance_test=fabs(Y-Ytest);
 *x=X1;
 *Y=Y;
 if (distance_test<=demi_segment)
 *distance=fabs(X1-X);
 else
 *distance=100000000;
 }
 if (Y1==Y2)
 {
 distance_test=fabs(Xtest-X);
 *x=X;
 *y=Y1;
 if (distance_test<=demi_segment)
 *distance=fabs(Y1-Y);
 else
 *distance=100000000;
 }
 if ((X1!=X2) && (Y1!=Y2))
 {
 a=(Y2-Y1)/(X2-X1);
 b=Y1-a*X1;
 a1=-1/a;
 b1=Y-a1*X;
 *x= (b1-b)/(a-a1);
 *y=a*(*x)+b;
 distance_test=hypot(((*x)-Xtest), ((*y)-Ytest));
  if (distance_test<=demi_segment)
  *distance=hypot(((*x)-X), ((*y)-Y));
 else
  *distance=100000000;
  }
  }
  /*************************************************************
  *******************
  * Enfin, on sélectionne les points ainsi que la distance qui
  correspondent à la distance minimale entre les deux polygones
  traités. *
  **************************************************************
  *******************/
  void selection_du_depot (x11,y11,x12,y12,x21,y21,x22,y22)
  double x11,y11,x12,y12,x21,y21,x22,y22;
  {double dist, X1, X2, Y1, Y2,d,x,y;
  * on calcule d'abord les dépôts possibles pour les quatre
  diagonales */
  * première diagonale */
  dist=hypot((x12-x21), (y12-y21));
  X1=x12 ;
  X2=x21;
  Y1=y12;
  Y2=y21;
  *deuxième diagonale */
  d=hypot((x12-x22), (y12-y22));
  if (d<=dist)
  {
  dist=d;
  X1=x12;
  X2=x22;
  Y1=y12;
  Y2=y22;
  }
  *troisième diagonale */
  d=hypot((x11-x21), (y11-y21));
  if (d<=dist)
  {
  dist=d;
  X1=x11;
  X2=x21 ;
  Y1=y11 ;
  Y2=y21 ;
  }
  *quatrième diagonale */
  d=hypot((x11-x22), (y11-y22));
  if (d<=dist)
  {
  dist=d;
  X1=x11;
  X2=x22 ;
  Y1=y11 ;
  Y2=y22 ;
  }
  * on calcule ensuite les dépôts possibles pour les quatre
  hauteurs */
  /* première hauteur entre le pt 12 et le segment 21-22 */
  calcul_hauteur (x21, y21, x22, y22, x12, y12, &d, &x, &y);
  if (d<=dist)
  {
  dist=d;
  X1=x12;
  X2=x;
  Y1=y12;
  Y2=y;
  }
  /* deuxième hauteur entre le pt 11 et le segment 21-22 */
  calcul_hauteur (x21, y21, x22, y22, x11, y11, &d, &x, &y) ;
  if (d<=dist)
  {
  dist=d;
  X1=x11;
  X2=x;
  Y1=y11;
  Y2=y;
  }
  /* troisième hauteur entre le pt 21 et le segment 11-12 */
  calcul_hauteur (x11, y11, x12, y12, x21, y21, &d, &x, &y);
  if (d<=dist)
  {
  dist=d;
  X1=x21;
  X2=x;
  Y1=y21;
  Y2=y;
  }
  /* troisième hauteur entre le pt 22 et le segment 11-12 */
  calcul_hauteur (x11, y11, x12, y12, x22, y22, &d, &x, &y);
  if (d<=dist)
  {
  dist=d;
  X1=x22;
  X2=x;
  Y1=y22;
  Y2=y;
  }
  * On a donc en mémoire, dans les variables dist, X1, X2, Y1,
  Y2, le dépôt optimal entre les deux polygones que l'on traite.
  */
  D=dist;
  Xm=X1;
  Ym=Y1;
  Xf=X2;
  Yf=Y2;
  }
  /*************************************************************
  *******************
  *Il s'agit ici d'une simple procédure de classement. On met à
  jour notre
  *tableau résultats contenant les 20 meilleurs dépôts à chaque
  nouveau calcul de*
  *dépôt. Si la note calculée est inférieure à la note max du
  Tableau, on
  *l'insère à la place adéquate.
  **************************************************************
  *******************/
  void mise_a_jour()
  {
  i=19;
  while ((note<resultats[i] .mark) && (i>=0))
    {
    i=i-1;
    }
    if (i<19)
 {
 for (j=19;j>i;j--)
      {
      resultats[j]=resultats[j-1];
      }
 resultats[i+1] .X1=Xm;
 resultats[i+1] .Y1=Ym;
 resultats[i+1] .X2=Xf;
 resultats[1+1] .Y2=Yf;
 resultats[i+1] .mark=note;
 resultats[i+1] .lf=l;
 resultats[i+1] .lm=k;
 }
 }
 /*************************************************************
 *******************
 * On calcule ici la note correspondant à un dépôt de distance
 minimale entre deux polygones, et on met à jour la liste des
 résultats. *
 **************************************************************
 *******************/
 void calcul_distance1(lm,lf)
 int lm, lf;
 {
 while (kikif=='P')
 {
    L21=fabs(Xfc-Xfb);
        L22=fabs(Yfa-Yfb) ;
  if (L21>L22)
 {
  Xf1=Xfa*echelle;
  Yf1=((Yfa+Yfb)*echelle)/2;
  Xf2=Xfc*echelle;
  Yf2=((Yfd+Yfc)*echelle)/2;
 }
 else
 {
  Xf1=((Xfa+Xfd)*echelle)/2;
  Yf1=Yfa*echelle;
  Xf2=((Xfc+Xfb)*echelle)/2;
  Yf2=Yfb*echelle;
 }
         selection_du_depot (Xm1,Ym1,Xm2,Ym2,Xf1,Yf1,Xf2,Yf2);
         coef=table[lm]*table[lf];
         note=coef*D;
         mise_a_jour();
         fprintf(result," %lf ", note );
          fgets(ligne,120,input2);
            sscanf(ligne,"%s %lf %lf %lf %lf %lf %lf %lf %lf ",
            &kikif, &Xfa, &Yfa, &Xfb, &Yfb, &Xfc, &Yfc, &Xfd, &Yfd);
            }
            }
            /*************************************************************
            *******************
            * Ici, pour chaque polygone du fichier CIF de
            l'équipotentielle mère, on * calcule les notes correspondant à
            tous les polygones du fichier CIF de l'équipotentielle fille*
            **************************************************************
            *******************/
            void calcul_distance2(lm)
            int lm;
            {
            while (kikim=='P')
 { L11=fabs(Xmc-Xmb);
        L12=fabs(Yma-Ymb);
 if (L11>L12)
 {
 Xm1=Xma*echelle
 Ym1=((Yma+Ymb)*echelle)/2;
 Xm2=Xmc*echelle;
 Ym2=((Ymd+Ymc)*echelle)/2;
  }
 else
 {
 Xm1=((Xma+Xmd)*echelle)/2;
 Ym1=Yma;
 Xm2=((Xmc+Xmb)*echelle)/2;
 Ym2=Ymb;
 }
     fgets (ligne, 120, input2) ;
     fgets (ligne, 120, input2) ;
     fgets (ligne, 120, input2) ;
     fgets (ligne, 120, input2) ;
     fgets (ligne, 120, input2) ;
     sscanf(ligne,"%s %lf %lf %lf %lf %lf %lf %lf %lf ",
     &kikif, &Xfa, &Yfa, &Xfb, &Yfb, &Xfc, &Yfc, &Xfd, &Yfd);
     for (k=0; k<=nombre_couches-2;k++)
     {
     calcul_distancel (lm, k);
     fgets (ligne, 120, input2) ;
     sscanf(ligne,"%s %lf %lf %lf %lf %lf %lf %lf %lf ",
     &kikif, &Xfa, &Yfa, &Xfb, &Yfb, &Xfc, &Yfc, &Xfd, &Yfd);
         }
           calcul_distancel(lm,nombre_couches-1);
    fprintf(result, " \n");
    rewind(input2);
    fgets(ligne,120,input1);
    sscanf(ligne,"%s %lf %lf %lf %lf %lf %lf %lf %lf ",
    &kikim,&Xma, &Yma, &Xmb, &Ymb, &Xmc, &Ymc, &Xmd, &Ymd);
 }
 }
 main(argc,argv)
 int argc;
 char *argv[];
 { if (argc!=5)
 {
 printf("Usage:./dep nombre_couches mere.cif fille.cif
 échelle. \n");
 exit(1);
 }
  table [0] =1;
  table [1] =2;
  table [2] =4;
  table [3] =8;
  table [4] =16;
  table [5] =1;
  table [6] =1;
  table [7] =1;
  table [8] =1;
  table [9] =1;
  /*************************************************************
  *******************
  * Il s'agit ici des coefficients multiplicateurs de note,
  correspondant à chaque couche (0=couche sup). *
  **************************************************************
  *******************/
 if ((input1=fopen(argv[2],"r")) == 0)
 {
   printf("Erreur durant création du fichier.\n\n");
   exit(1);
 }
 if ((input2=fopen(argv[3],"r")) == 0)
 {
   printf("Erreur durant création du fichier.\n\n");
   exit(1);
 }
 init_resultats();
 nombre_couches=atoi(argv[1]);
 result=fopen("TABLEAU", "w");
 echelle=atof(argv[4]);
 fgets(ligne,120,input1);
 fgets(ligne,120,input1);
 fgets(ligne,120,input1);
 fgets(ligne,120,input1);
 fgets(ligne,120,input1);
 sscanf(ligne,"%s %lf %lf %lf %lf %lf %lf %lf %lf ", &kikim,
 &Xma, &Yma, &Xmb, &Ymb, &Xmc, &Ymc, &Xmd, &Ymd);
 /*************************************************************
 *******************
 * Dans le main, il ne nous reste plus qu'à lancer
 calcul_distance2 sur tous les polygones de l'équipotentielle
 mère. *
 **************************************************************
 *******************/
 for(1=0;1<=nombre_couches-2;1++)
 {
 calcul distance2(1);
 fgets(ligne,120,input1);
 sscanf(ligne,"%s %lf %lf %lf %lf %lf %lf %lf %lf ",
 &kikim,&Xma, &Yma, &Xmb, &Ymb, &Xmc, &Ymc, &Xmd, &Ymd);
 }
 calcul_distance2(nombre_couches-1):
 for (i=0;i<=19;i++)
 printf("N%d %lf, x1 %lf, y1 %lf, lm %d, x2 %lf, y2 %lf, lf %d
 \n", i , resultats[i] .mark,
 resultats[i] .X1, resultats[i] .Y1,resultats[i] .lm,
 resultats[i] .X2, resultats[i] .Y2,resultats[i] .lf);
 fclose(inputl);
 fclose(input2);
 fclose(result);
 }
```

## Revendications

1. - Procédé de localisation optimale automatique d'une opération d'intervention sur un circuit intégré (3) comportant plusieurs couches physiques définissant un schéma électrique à plusieurs éléments fonctionnels électriques, cette opération d'intervention comprenant au moins une étape appliquée en une zone localisée accessible du côté d'une face, dite face d'intervention (5) du circuit (3), à au moins un élément du schéma électrique, ce procédé comprenant une étape, dite étape d'extraction de polygones accessibles, dans laquelle à partir, d'une part, de données de description topographique identifiant, dans chaque couche du circuit (3), des polygones formés chacun d'un matériau caractéristique du circuit (3) et, d'autre part, de données représentatives du schéma électrique, on calcule selon des critères d'accessibilité des données identifiant, pour au moins chaque élément du schéma électrique auquel au moins une étape de l'opération d'intervention doit être appliquée, les différents polygones, dits polygones accessibles, définissant cet élément dans chaque couche du circuit (3), et sur lesquels des moyens d'intervention peuvent être positionnés et peuvent effectuer au moins une étape de l'opération d'intervention depuis la face d'intervention (5),
et dans lequel :
- on détermine, pour chaque étape de l'opération d'intervention, différentes options d'exécution de cette étape correspondant respectivement à chacun des différents polygones accessibles, dits polygones de départ possibles, sur lesquels cette étape peut être exécutée, les différentes options d'exécution produisant toutes des résultats qui sont équivalents au regard du schéma électrique, et on calcule et on affecte une note à chaque option d'exécution en fonction :
. de la profondeur de chaque polygone de départ possible de cette option d'exécution, représentée par la distance séparant la couche comprenant ce polygone de la face d'intervention (5), et
. de paramètres d'accessibilité de chaque polygone de départ possible de cette option d'exécution,
- on détermine automatiquement l'option d'exécution optimale à utiliser pour exécuter chaque étape de l'opération d'intervention, par un calcul d'optimisation numérique utilisant les notes affectées aux différentes options d'exécution de chaque étape de l'opération d'intervention,
**caractérisé en ce que** lors de l'étape d'extraction, pour chaque élément on calcule et on génère des données identifiant au moins une série de polygones accessibles qui satisfont aux conditions suivantes :
- ils présentent une surface, dite surface accessible réduite, correspondant à une surface non masquée du côté de la face d'intervention par une couche supérieure de matériau de même nature, et dont la dimension dans chaque direction entre deux éléments supérieurs, est diminuée d'une valeur αi qui dépend de la profondeur de la couche du polygone et de la nature des moyens d'intervention destinés à être utilisés sur cet élément,
- la dimension dans chaque direction de la surface accessible réduite est supérieure à une valeur seuil minimale β,
- ladite surface accessible réduite est distante de tous les polygones de matériau de même nature appartenant à un autre élément, d'une distance supérieure à une valeur λ prédéterminée.

2. - Procédé selon la revendication 1, **caractérisé en ce que** le calcul d'optimisation est adapté pour faciliter l'exécution de l'opération d'intervention et/ou en optimiser la qualité de réalisation et/ou en minimiser la durée totale.

3. Procédé selon l'une des revendications 1 ou 2, caractérisé à ce que le calcul d'optimisation est adapté pour retenir pour chaque étape, une option d'exécution optimale telle qu'une fonction multi-polynomiale -notamment le produit- des notes des options d'exécution des différentes étapes présente une valeur optimum.

4. Procédé selon l'une des revendications 1 à 3, **caractérisé en ce qu'**on calcule et on génère, pour chaque élément, des données de plusieurs séries de polygones accessibles avec, pour chaque série, un jeu de valeurs des paramètres αi, β et λ, **en ce qu'**on calcule et on affecte un coefficient d'accessibilité à chaque série et à partir des valeurs des paramètres αi, β et λ, et **en ce qu'**on utilise ce coefficient d'accessibilité à titre de paramètre d'accessibilité lors du calcul de la note des options d'exécution de chaque étape effectuée sur cet élément.

5. Procédé selon la revendication 4, **caractérisé en ce qu'**on affecte à chaque polygone de départ possible un coefficient de profondeur qui varie en fonction de sa profondeur et **en ce qu'**on calcule la note de chaque option d'exécution selon une fonction bipolynomiale du coefficient de profondeur et du coefficient d'accessibilité de chaque polygone de départ possible.

6. Procédé selon l'une des revendications 1 à 5, **caractérisé en ce qu'**on utilise l'aire de la surface accessible réduite de chaque polygone de départ possible à titre de paramètre d'accessibilité.

7. Procédé selon l'une des revendications précédentes, **caractérisé en ce qu'**on utilise des paramètres d'accessibilité choisis selon la nature de l'étape à effectuer et/ou selon des caractéristiques d'au moins un outil (4) d'intervention utilisé pour exécuter cette étape.

8. Procédé selon l'une des revendications précédentes, **caractérisé en ce que** lesdites données identifiant les polygones accessibles obtenus par l'étape d'extraction sont des données numériques selon un format compatible avec un logiciel d'affichage simultané d'au moins une partie des données d'implantation et des données du schéma électrique correspondant les unes aux autres.

9. Procédé selon l'une des revendications précédentes, **caractérisé en ce que** l'opération d'intervention consistant en une coupure (17) d'une piste (10) de matériau conducteur formant une équipotentielle du schéma électrique :
- on extrait, lors de l'étape d'extraction, les polygones accessibles d'une branche de la piste (10), dite branche réduite amont (16), s'étendant entre un point d'entrée (IN) prédéterminé et le premier noeud (11) de dérivation rencontré selon un sens prédéterminé à l'aval du point d'entrée (IN),
- on calcule et on affecte une note d'accessibilité à chaque polygone accessible de la branche réduite amont (16), qui constitue une option d'exécution pour effectuer la coupure (17),
- on détermine automatiquement l'option d'exécution optimale pour réaliser la coupure (17) en choisissant, parmi les polygones accessibles qui présentent une note d'accessibilité optimale, celui qui est le plus proche du point d'entrée (IN).

10. Procédé selon l'une des revendications 1 à 8, **caractérisé en ce que** l'opération d'intervention consistant à réaliser un dépôt (18) de matériau conducteur entre une piste, dite piste mère (20), de matériau conducteur formant une équipotentielle, dite équipotentielle mère, du schéma électrique, et une piste, dite piste fille (10), de matériau conducteur formant une équipotentielle, dite équipotentielle fille, du schéma électrique, chaque option d'exécution comprenant un polygone de départ possible, dit polygone mère (Pm), de la piste mère (20), et un polygone de départ possible, dit polygone fille (Pf), de la piste fille (10), on détermine automatiquement l'option d'exécution optimale à partir d'au moins un calcul de distance D(Pm, Pf) entre le polygone mère (Pm) et le polygone fille (Pf), en visant à minimiser cette distance.

11. Procédé selon la revendication 10, **caractérisé en ce qu'**on calcule la distance D(Pm, Pf) entre les polygones en considérant chaque polygone comme représenté par un segment de droite projeté dans un même plan parallèle à la face d'intervention (5).

12. Procédé selon l'une des revendications 10 ou 11, **caractérisé en ce qu'**on calcule la distance D(Pm, Pf) entre les polygones comme la plus petite valeur des quatre distances (de1, de2, de3, de4) calculées entre leurs extrémités (31 à 34) respectives, et des distances (dp1, dp4) entre chaque extrémité (31 à 34) d'un de ces polygones (Pm, Pf) et la projection orthogonale (PP1 à PP4) de cette extrémité (31, 34), si elle existe, sur l'autre polygone (Pf, Pm).

13. Procédé selon l'une des revendications 10 à 12, **caractérisé en ce qu'**on détermine l'option d'exécution optimale en optimisant la valeur d'une note d'exécution NEX de formule NEX=f(D(Pm, Pf), NACC(Pm), NACC(Pf)) où D(Pm,Pf) est la distance calculée entre les polygones mère (Pm) et fille (Pf) , et NACC(Pm) et NACC(Pf) sont des notes d'accessibilité des polygones mère (Pm) et, respectivement, fille (Pf) calculées de façon à être minimales pour les polygones de moindre profondeur et les plus accessibles, et f est une fonction multipolynomiale.

14. Procédé selon l'une des revendications 1 à 8, **caractérisé en ce que** l'opération d'intervention comprend une pluralité d'étapes.

15. Procédé selon l'une des revendications 1 à 8, **caractérisé en ce que** l'opération d'intervention consistant à réaliser une étape de coupure (17) d'une piste, dite piste fille (10), de matériau conducteur formant une équipotentielle, dite équipotentielle fille du schéma électrique, et une étape de dépôt d'une piste de matériau conducteur (18) entre une piste, dite piste mère (20), de matériau conducteur formant une équipotentielle, dite équipotentielle mère, du schéma électrique, et une portion résiduelle (16a) de la piste fille (10) entre la coupure (17) et un premier noeud (11) de dérivation rencontré selon un sens prédéterminé à l'aval de la coupure (17),
- on extrait, lors de l'étape d'extraction, au moins tous les polygones accessibles de chaque piste mère (20) et fille (10),
- on calcule et on affecte une note d'exécution à chaque option d'exécution de l'étape de dépôt en considérant tous les polygones accessibles de la piste mère (20) et de la piste fille (10),
- on calcule et on affecte une note d'exécution à chaque option d'exécution de l'étape de coupure,
- on détermine automatiquement le meilleur compromis d'étape de coupure et d'étape de dépôt, en déterminant, pour chaque option d'exécution de l'étape de coupure, l'option d'exécution optimale (DEPOPT) de l'étape de dépôt correspondant à cette option d'exécution de l'étape de coupure, en considérant, pour les options d'exécution de l'étape de dépôt, uniquement les polygones accessibles de la portion (16b) de la branche réduite amont de la piste fille (10) s'étendant entre la coupure (17) et le noeud (11) topologique de dérivation.

16. Installation comprenant :
- des moyens (2) de réception d'un circuit intégré (3) comportant plusieurs couches physiques définissant un schéma électrique à plusieurs éléments fonctionnels électriques, et
- des moyens (4) d'intervention sur au moins une face, dite face d'intervention (5), d'un circuit intégré (3) placé sur les moyens (2) de réception, ces moyens (4) d'intervention étant adaptés pour permettre d'effectuer une opération d'intervention prédéterminée comprenant au moins une étape appliquée en une zone localisée accessible du côté de la face d'intervention, à au moins un élément du schéma électrique,
- des moyens, dits moyens d'extraction de polygones accessibles, de calcul selon des critères d'accessibilité et à partir, d'une part, de données de description topographique identifiant, dans chaque couche du circuit (3), des polygones formés chacun d'un matériau caractéristique du circuit (3) et, d'autre part, de données représentatives du schéma électrique, de données identifiant, pour au moins chaque élément du schéma électrique auquel au moins une étape de l'opération d'intervention doit être appliquée, les différents polygones, dits polygones accessibles, définissant cet élément dans chaque couche du circuit (3), et sur lesquels les moyens (4) d'intervention peuvent être positionnés et peuvent effectuer au moins une étape de l'opération d'intervention depuis la face d'intervention (5),
- des moyens pour déterminer, pour chaque étape de l'opération d'intervention, différentes options d'exécution de cette étape correspondant respectivement à chacun des différents polygones accessibles, dits polygones de départ possibles, sur lesquels cette étape peut être exécutée, les différentes options d'exécution produisant toutes des résultats qui sont équivalents au regard du schéma électrique, et pour calculer et affecter une note à chaque option d'exécution en fonction :
. de la profondeur de chaque polygone de départ possible de cette option d'exécution, représentée par la distance séparant la couche comprenant ce polygone de la face d'intervention (5), et
. de paramètres d'accessibilité de chaque polygone de départ possible de cette option d'exécution,
- des moyens pour déterminer automatiquement l'option d'exécution optimale à utiliser pour exécuter chaque étape de l'opération d'intervention, par un calcul d'optimisation numérique utilisant les notes affectées aux différentes options d'exécution de chaque étape de l'opération d'intervention ?
**caractérisée en ce que** lesdits moyens d'extraction de polygones accessibles sont adaptés pour calculer et générer, pour chaque élément, des données identifiant au moins une série de polygones accessibles qui satisfont aux conditions suivantes :
- ils présentent une surface, dite surface accessible réduite, correspondant à une surface non masquée du côté de la face d'intervention par une couche supérieure de matériau de même nature, et dont la dimension dans chaque direction entre deux éléments supérieurs, est diminuée d'une valeur αi qui dépend de la profondeur de la couche du polygone et de la nature des moyens d'intervention destinés à être utilisés sur cet élément,
- la dimension dans chaque direction de la surface accessible réduite est supérieure à une valeur seuil minimale β,
- ladite surface accessible réduite est distante de tous les polygones de matériau de même nature appartenant à un autre élément, d'une distance supérieure à une valeur λ prédéterminée.

17. Installation selon la revendication 16, **caractérisée en ce qu'**elle est adaptée pour mettre en oeuvre un procédé selon l'une des revendications 1 à 15.

## Patentansprüche

1. Verfahren zur automatischen optimalen Lokalisierung eines Eingriffsvorgangs an einer integrierten Schaltung (3), die mehrere physische Schichten umfasst, die einen Schaltplan mit mehreren elektrischen Funktionselementen definieren, wobei dieser Eingriffsvorgang mindestens einen Schritt umfasst, der auf eine örtlich begrenzte Zone angewendet wird, die von der Seite einer Fläche, der so genannten Eingriffsfläche (5) der Schaltung (3), aus für mindestens ein Element des Schaltplans zugänglich ist, wobei dieses Verfahren einen Schritt, den so genannten Schritt zum Entnehmen zugänglicher Vielecke, umfasst, bei dem einerseits aus topographischen Beschreibungsdaten, die in jeder Schicht der Schaltung (3) Vielecke identifizieren, die jeweils aus einem charakteristischen Material der Schaltung (3) gebildet sind, und andererseits aus Daten, die für den Schaltplan repräsentativ sind, gemäß Zugangskriterien Daten berechnet werden, die für mindestens jedes Element des Schaltplans, auf das mindestens ein Schritt des Eingriffsvorgangs anzuwenden ist, die verschiedenen Vielecke, die so genannten zugänglichen Vielecke, identifizieren, die dieses Element in jeder Schicht der Schaltung (3) definieren, und auf denen Eingriffsmittel positioniert werden können und mindestens einen Schritt des Eingriffsvorgangs von der Eingriffsfläche (5) aus ausführen können,
und wobei:
- für jeden Schritt des Eingriffsvorgangs verschiedene Durchführungsoptionen dieses Schritts bestimmt werden, die jeweils jedem der verschiedenen zugänglichen Vielecke, den so genannten möglichen Ausgangsvielecken, entsprechen, an denen dieser Schritt durchgeführt werden kann, wobei die verschiedenen Durchführungsoptionen alle Ergebnisse erzeugen, die im Hinblick auf den Schaltplan gleichwertig sind, und für jede Durchführungsoption eine Note berechnet und zugeordnet wird, und zwar in Abhängigkeit von:
-- der Tiefe jedes möglichen Ausgangsvielecks dieser Durchführungsoption, die durch den Abstand dargestellt wird, der die Schicht, die dieses Vieleck umfasst, von der Eingriffsfläche (5) trennt, und
-- Zugänglichkeitsparametern jedes möglichen Ausgangsvielecks dieser Durchführungsoption,
- die optimale Durchführungsoption, die zu verwenden ist, um jeden Schritt des Eingriffsvorgangs durchzuführen, durch eine nummerische Optimierungsberechnung unter Verwendung der Noten, die den verschiedenen Durchführungsoptionen jedes Schritts des Eingriffsvorgangs zugeordnet sind, automatisch bestimmt wird,
**dadurch gekennzeichnet, dass** bei dem Schritt des Entnehmens für jedes Element Daten berechnet und generiert werden, die mindestens eine Reihe zugänglicher Vielecke identifizieren, die folgende Bedingungen erfüllen:
- sie weisen eine Oberfläche, die so genannte reduzierte zugängliche Oberfläche, auf, die einer Oberfläche entspricht, die auf der Seite der Eingriffsfläche nicht durch eine gleichartige obere Materialschicht maskiert ist und deren Dimension in jeder Richtung zwischen zwei oberen Elementen um einen Wert αi verringert ist, der von der Tiefe der Schicht des Vielecks und der Beschaffenheit der Eingriffsmittel abhängig ist, die an diesem Element verwendet werden sollen,
- die Dimension in jeder Richtung der reduzierten zugänglichen Oberfläche ist größer als ein minimaler Schwellenwert β,
- die reduzierte zugängliche Oberfläche ist von allen Vielecken aus gleichartigem Material, die zu einem anderen Element gehören, um einen Abstand, der größer als ein vorbestimmter Wert λ ist, entfernt.

2. Verfahren nach Anspruch 1, **dadurch gekennzeichnet, dass** die Optimierungsberechnung dazu geeignet ist, um die Durchführung des Eingriffsvorgangs zu erleichtern und/oder um seine Ausführungsqualität zu optimieren und/oder um die Gesamtdauer zu minimieren.

3. Verfahren nach einem der Ansprüche 1 oder 2, **dadurch gekennzeichnet, dass** die Optimierungsberechnung dazu geeignet ist, um für jeden Schritt eine optimale Durchführungsoption, wie etwa eine mehrfache Polynomfunktion - insbesondere das Produkt -, der Noten der Durchführungsoptionen der verschiedenen Schritte zu berücksichtigen, die einen optimalen Wert aufweist.

4. Verfahren nach einem der Ansprüche 1 bis 3, **dadurch gekennzeichnet, dass** für jedes Element Daten von mehreren Reihen zugänglicher Vielecke mit für jede Reihe einem Satz Werten der Parameter αi, β und λ berechnet und generiert werden, und dass ein Zugänglichkeitskoeffizient auf jeder Reihe und aus den Werten der Parameter αi, β und λ berechnet und zugeordnet wird, und dass dieser Zugänglichkeitskoeffizient als Zugänglichkeitsparameter bei der Berechnung der Note der Durchführungsoptionen jedes Schritts, der an diesem Element ausgeführt wird, verwendet wird.

5. Verfahren nach Anspruch 4, **dadurch gekennzeichnet, dass** jedem möglichen Ausgangsvieleck ein Tiefenkoeffizient zugeordnet wird, der in Abhängigkeit von seiner Tiefe variiert, und dass die Note jeder Durchführungsoption gemäß einer zweifachen Polynomfunktion des Tiefenkoeffizienten und des Zugänglichkeitskoeffizienten jedes möglichen Ausgangsvielecks berechnet wird.

6. Verfahren nach einem der Ansprüche 1 bis 5, **dadurch gekennzeichnet, dass** der Flächeninhalt der reduzierten zugänglichen Oberfläche jedes möglichen Ausgangsvielecks als Zugänglichkeitsparameter verwendet wird.

7. Verfahren nach einem der vorhergehenden Ansprüche, **dadurch gekennzeichnet, dass** Zugänglichkeitsparameter verwendet werden, die gemäß der Beschaffenheit des auszuführenden Schritts und/oder gemäß Charakteristiken mindestens eines Eingriffswerkzeugs (4), das verwendet wird, um diesen Schritt auszuführen, ausgewählt werden.

8. Verfahren nach einem der vorhergehenden Ansprüche, **dadurch gekennzeichnet, dass** die Daten, welche die zugänglichen Vielecke identifizieren, die durch den Schritt des Entnehmens erzielt werden, nummerische Daten gemäß einem Format sind, das mit einer Software zum gleichzeitigen Anzeigen mindestens eines Teils der Montagedaten und der Daten des Schaltplans, die einander entsprechen, kompatibel ist.

9. Verfahren nach einem der vorhergehenden Ansprüche, **dadurch gekennzeichnet, dass** bei dem Eingriffsvorgang, der aus dem Schneiden (17) einer Bahn (10) aus Leitermaterial besteht, die eine Äquipotentiallinie des Schaltplans bildet:
- bei dem Schritt des Entnehmens die zugänglichen Vielecke eines Zweigs der Bahn (10), des so genannten stromaufwärtigen reduzierten Zweigs (16), der sich zwischen einem vorbestimmten Eingangspunkt (IN) und dem ersten Nebenschlussknoten (11), der in einer vorbestimmten Richtung stromabwärts von dem Eingangspunkt (IN) vorgefunden wird, erstreckt, entnommen werden,
- eine Zugänglichkeitsnote für jedes zugängliche Vieleck des stromaufwärtigen reduzierten Zweigs (16) berechnet und zugeordnet wird, der eine Durchführungsoption zum Ausführen des Schneidens (17) ist,
- automatisch die optimale Durchführungsoption bestimmt wird, um das Schneiden (17) auszuführen, indem aus den zugänglichen Vielecken, die eine optimale Zugänglichkeitsnote aufweisen, dasjenige ausgewählt wird, das dem Eintrittspunkt (IN) am nächsten ist.

10. Verfahren nach einem der Ansprüche 1 bis 8, **dadurch gekennzeichnet, dass** bei dem Eingriffsvorgang, der darin besteht, eine Abscheidung (18) von leitfähigem Material zwischen einer Bahn, der so genannten Hauptbahn (20), aus leitfähigem Material, das eine Äquipotentiallinie, die so genannte Hauptäquipotentiallinie, des Schaltplans bildet, und einer Bahn, der so genannten Nebenbahn (10), aus leitfähigem Material, das eine Äquipotentiallinie, die so genannte Nebenäquipotentiallinie, des Schaltplans bildet, wobei jede Durchführungsoption ein mögliches Ausgangsvieleck, das so genannte Hauptvieleck (Pm), der Hauptbahn (20), und ein mögliches Ausgangsvieleck, das so genannte Nebenvieleck (Pf), der Nebenbahn (10) umfasst, automatisch die optimale Durchführungsoption aus mindestens einer Abstandsberechnung D(Pm, Pf) zwischen dem Hauptvieleck (Pm) und dem Nebenvieleck (Pf) bestimmt wird, wobei versucht wird, diesen Abstand zu minimieren.

11. Verfahren nach Anspruch 10, **dadurch gekennzeichnet, dass** der Abstand D(Pm, Pf) zwischen den Vielecken berechnet wird, in dem man davon ausgeht, dass jedes Vieleck durch eine Strecke dargestellt wird, die in derselben Ebene parallel zur Eingriffsfläche (5) projiziert wird.

12. Verfahren nach einem der Ansprüche 10 oder 11, **dadurch gekennzeichnet, dass** der Abstand D(Pm, Pf) zwischen den Vielecken als der kleinste Wert der vier Abstände (de1, de2, de3, de4), die zwischen ihren jeweiligen Enden (31 bis 34) berechnet werden, und der Abstände (dp1, dp4) zwischen jedem Ende (31 bis 34) eines dieser Vielecke (Pm, Pf) und gegebenenfalls der orthogonalen Projektion (PP1 bis PP4) dieses Endes (31, 34) auf dem anderen Vieleck (Pf, Pm) berechnet wird.

13. Verfahren nach einem der Ansprüche 10 bis 12, **dadurch gekennzeichnet, dass** die optimale Durchführungsoption bestimmt wird, indem der Wert einer Durchführungsnote NEX mit der Formel NEX = f(D(Pm, Pf), NACC(Pm), NACC(Pf)) optimiert wird, wobei D(Pm, Pf) der Abstand ist, der zwischen den Hauptvielecken (Pm) und den Nebenvielecken (Pf) berechnet wird, und NACC(Pm) und NACC(Pf) Zugänglichkeitsnoten jeweils der Hauptvielecke (Pm) und der Nebenvielecke (Pf) sind, die derart berechnet werden, dass sie für die zugänglichsten Vielecke geringerer Tiefe minimal sind, und f eine mehrfache Polynomfunktion ist.

14. Verfahren nach einem der Ansprüche 1 bis 8, **dadurch gekennzeichnet, dass** der Eingriffsvorgang eine Vielzahl von Schritten umfasst.

15. Verfahren nach einem der Ansprüche 1 bis 8, **dadurch gekennzeichnet, dass** bei dem Eingriffsvorgang, der darin besteht, einen Schritt des Schneidens (17) einer Bahn, der so genannten Nebenbahn (10), aus leitfähigem Material, die eine Äquipotentiallinie, die so genannte Nebenäquipotentiallinie des Schaltplans bildet, und einen Schritt des Abscheidens einer Bahn aus leitfähigem Material (18) zwischen einer Bahn, der so genannten Hauptbahn (20), aus leitfähigem Material, die eine Äquipotentiallinie, die so genannte Hauptäquipotentiallinie, des Schaltplans bildet, und einem Restabschnitt (16a) der Nebenbahn (10) zwischen dem Schnitt (17) und einem ersten Nebenschlussknoten (11), auf den man in einer vorbestimmten Richtung stromabwärts von dem Schnitt (17) trifft, auszuführen,
- in dem Schritt des Entnehmens mindestens alle zugänglichen Vielecke jeder Hauptbahn (20) und Nebenbahn (10) entnommen werden,
- eine Ausführungsnote bei jeder Durchführungsoption des Schritts des Abscheidens berechnet und zugeordnet wird, wobei alle Vielecke berücksichtigt werden, die von der Hauptbahn (20) und der Nebenbahn (10) aus zugänglich sind,
- eine Ausführungsnote bei jeder Durchführungsoption des Schritts des Schneidens berechnet und zugeordnet wird,
- automatisch der beste Kompromiss zwischen dem Schritt des Schneidens und dem Schritt des Abscheidens bestimmt wird, indem für jede Durchführungsoption des Schritt des Schneidens die optimale Durchführungsoption (DEPOPT) des Schritts des Abscheidens bestimmt wird, die dieser Durchführungsoption des Schritts des Schneidens entspricht, wobei für die Durchführungsoptionen des Schritts des Abscheidens nur die Vielecke berücksichtigt werden, die von dem Abschnitt (16b) des stromaufwärtigen reduzierten Zweigs der Nebenbahn (10) aus zugänglich sind, die sich zwischen dem Schnitt (17) und dem topologischen Nebenschlussknoten (11) erstreckt.

16. Einrichtung, umfassend:
- Mittel (2) zum Aufnehmen einer integrierten Schaltung (3), die mehrere physische Schichten umfasst, die einen Schaltplan mit mehreren elektrischen Funktionselementen definieren, und
- Mittel (4) zum Eingreifen auf mindestens einer Fläche, der so genannten Eingriffsfläche (5), einer integrierten Schaltung (3), die auf die Aufnahmemittel (2) gelegt wird, wobei diese Eingriffsmittel (4) dazu geeignet sind, um es zu ermöglichen, einen vorbestimmten Eingriffsvorgang auszuführen, der mindestens einen Schritt umfasst, der in einer örtlich begrenzten Zone, die von der Seite der Eingriffsfläche aus zugänglich ist, auf mindestens ein Element des Schaltplans angewendet wird,
- Mittel, so genannte Mittel zum Entnehmen zugänglicher Vielecke, zum Berechnen gemäß Zugänglichkeitskriterien einerseits aus topographischen Beschreibungsdaten, die in jeder Schicht der Schaltung (3) Vielecke definieren, die jeweils aus einem charakteristischen Material der Schaltung (3) gebildet sind, und andererseits aus Daten, die für den Schaltplan repräsentativ sind, von Daten, die für mindestens jedes Element des Schaltplans, auf das mindestens ein Schritt des Eingriffsvorgangs anzuwenden ist, die verschiedenen Vielecke, so genannten zugänglichen Vielecke, identifizieren, die dieses Element in jeder Schicht der Schaltung (3) definieren, und auf denen die Eingriffsmittel (4) positioniert werden können und mindestens einen Schritt des Eingriffsvorgangs von der Eingriffsfläche (5) aus ausführen können,
- Mittel zum Bestimmen für jeden Schritt des Eingriffsvorgangs verschiedener Durchführungsoptionen dieses Schritts, die jeweils jedem der verschiedenen zugänglichen Vielecke entsprechen, den so genannten möglichen Ausgangsvielecken, an denen dieser Schritt ausgeführt werden kann, wobei die verschiedenen Durchführungsoptionen alle Ergebnisse erzeugen, die im Hinblick auf den Schaltplan gleichwertig sind, und um eine Note bei jeder Durchführungsoption zu berechnen und zuzuordnen, und zwar in Abhängigkeit von:
-- der Tiefe jedes möglichen Ausgangsvielecks dieser Durchführungsoption, die durch den Abstand dargestellt wird, der die Schicht, die dieses Vieleck umfasst, von der Eingriffsfläche (5) trennt, und
-- Zugänglichkeitsparametern jedes möglichen Ausgangsvielecks dieser Durchführungsoption,
- Mittel zum automatischen Bestimmen der optimalen Durchführungsoption, die zu verwenden sind, um jeden Schritt des Eingriffsvorgangs durch eine nummerische Optimierungsberechnung unter Verwendung der Noten, die den verschiedenen Durchführungsoptionen jedes Schritts des Eingriffsvorgangs zugeordnet werden, durchzuführen,
**dadurch gekennzeichnet, dass** die Mittel zum Entnehmen zugänglicher Vielecke dazu geeignet sind, um für jedes Element Daten zu berechnen und zu generieren, die mindestens eine Reihe zugänglicher Vielecke identifizieren, die folgende Bedingungen erfüllen:
- sie weisen eine Oberfläche, die so genannte reduzierte zugängliche Oberfläche, auf, die einer Oberfläche entspricht, die auf der Seite der Eingriffsfläche nicht durch eine gleichartige obere Materialschicht maskiert ist und deren Dimension in jeder Richtung zwischen zwei oberen Elementen um einen Wert αi verringert ist, der von der Tiefe der Schicht des Vielecks und der Beschaffenheit der Eingriffsmittel abhängig ist, die an diesem Element verwendet werden sollen,
- die Dimension in jeder Richtung der reduzierten zugänglichen Oberfläche ist größer als ein minimaler Schwellenwert β,
- die reduzierte zugängliche Oberfläche ist von allen Vielecken aus gleichartigem Material, die zu einem anderen Element gehören, um einen Abstand, der größer als ein vorbestimmter Wert λ ist, entfernt.

17. Einrichtung nach Anspruch 16, **dadurch gekennzeichnet, dass** sie dazu geeignet ist, um ein Verfahren nach einem der Ansprüche 1 bis 15 umzusetzen.

## Claims

1. A process for automatic optimal locating of a servicing operation on an integrated circuit (3) comprising several physical layers defining an electrical configuration having several electrical functional elements, this servicing operation comprising at least one step applied in a localised zone which is accessible from one side, called the servicing side (5) of the circuit (3), to at least one element of the electrical configuration, this process including a step, called the step of retrieval of accessible polygons, in which, on the basis of, on the one hand, topographic-description data identifying, in each layer of the circuit (3), polygons each formed from a characteristic material of the circuit (3), and, on the other hand, data that are representative of the electrical configuration, data identifying, for at least each element of the electrical configuration to which at least one step of the servicing operation has to be applied, the various polygons, called the accessible polygons, defining this element in each layer of the circuit (3), and on which servicing means can be positioned and can perform at least one step of the servicing operation from the servicing side (5), are calculated in accordance with accessibility criteria,
and in which:
- for each step of the servicing operation various options for execution of this step are determined, corresponding respectively to each of the various accessible polygons, called the possible initial polygons, on which this step can be executed, all the various execution options producing results that are equivalent from the point of view of the electrical configuration, and a score is calculated and is assigned to each execution option as a function of:
. the depth of each possible initial polygon of this execution option, represented by the distance separating the layer including this polygon from the servicing side (5), and
. accessibility parameters for each possible initial polygon of this execution option,
- the optimal execution option to be used for executing each step of the servicing operation is determined automatically by a numerical optimisation calculation using the scores assigned to the various options for execution of each step of the servicing operation,
**characterised in that** in the course of the retrieval step, for each element, data are calculated and generated identifying at least one series of accessible polygons that satisfy the following conditions:
- they have a surface, called the reduced accessible surface, corresponding to a surface which is not masked from the servicing side by a higher layer of material of the same kind, and the dimension of which in each direction between two higher elements is decreased by a value αi which depends on the depth of the layer of the polygon and on the nature of the servicing means intended to be used on this element,
- the dimension in each direction of the reduced accessible surface is greater than a minimal threshold value β,
- said reduced accessible surface is remote from all the polygons of material of the same kind pertaining to another element by a distance greater than a predetermined value λ.

2. A process according to Claim 1, **characterised in that** the optimisation calculation is suitable to facilitate the execution of the servicing operation and/or to optimise the quality of realisation thereof and/or to minimise the total duration thereof.

3. A process according to one of Claims 1 or 2, **characterised in that** the optimisation calculation is suitable to retain, for each step, an optimal execution option such that a multipolynomial function - in particular the product - of the scores of the execution options of the various steps has an optimum value.

4. A process according to one of Claims 1 to 3, **characterised in that**, for each element, data for several series of accessible polygons are calculated and generated with, for each series, a set of values of the parameters αi, β and λ, **in that** an accessibility coefficient is calculated and is assigned to each series on the basis of the values of the parameters αi, β and λ, and **in that** this accessibility coefficient is used by way of accessibility parameter in the course of the calculation of the score of the execution options for each step performed on this element.

5. A process according to Claim 4, **characterised in that** to each possible initial polygon a depth coefficient is assigned which varies as a function of the depth of the polygon, and **in that** the score of each execution option is calculated in accordance with a bipolynomial function of the depth coefficient and of the accessibility coefficient of each possible initial polygon.

6. A process according to one of Claims 1 to 5, **characterised in that** the area of the reduced accessible surface of each possible initial polygon is used by way of accessibility parameter.

7. A process according to one of the preceding claims, **characterised in that** accessibility parameters are used that have been chosen in accordance with the nature of the step to be performed and/or in accordance with the characteristics of at least one servicing tool (4) being used for executing this step.

8. A process according to one of the preceding claims, **characterised in that** said data identifying the accessible polygons obtained by the retrieval step are numerical data according to a format that is compatible with a software for simultaneous display of at least some of the layout data and of the electrical-configuration data corresponding to one another.

9. A process according to one of the preceding claims, **characterised in that** when the servicing operation consists in a cutting (17) of a track (10) of conductive material forming an equipotential region of the electrical configuration:
- in the course of the retrieval step the accessible polygons of one branch of the track (10), called the upstream reduced branch (16), extending between a predetermined input point (IN) and the first shunt node (11) encountered in a predetermined direction downstream of the input point (IN) are retrieved,
- an accessibility score is calculated and is assigned to each accessible polygon of the upstream reduced branch (16) that constitutes an execution option for performing the cutting (17),
- the optimal execution option for realising the cutting (17) is determined automatically by selecting, from the accessible polygons that have an optimal accessibility score, the one that is closest to the input point (IN).

10. A process according to one of Claims 1 to 8, **characterised in that** when the servicing operation consists in realising a deposition (18) of conductive material between a track, called the mother track (20), of conductive material forming an equipotential region, called the mother equipotential region, of the electrical configuration and a track, called the daughter track (10), of conductive material forming an equipotential region, called the daughter equipotential region, of the electrical configuration, each execution option including a possible initial polygon, called the mother polygon (Pm), of the mother track (20), and a possible initial polygon, called the daughter polygon (Pf), of the daughter track (10), the optimal execution option is determined automatically on the basis of at least one distance D(Pm, Pf) calculation between the mother polygon (Pm) and the daughter polygon (Pf), aiming to minimise this distance.

11. A process according to Claim 10, **characterised in that** the distance D(Pm, Pf) between the polygons is calculated by considering each polygon to be represented by a straight-line segment projected in the same plane parallel to the servicing side (5).

12. A process according to one of Claims 10 or 11, **characterised in that** the distance D(Pm, Pf) between the polygons is calculated as the smallest value of the four distances (de1, de2, de3, de4) calculated between their respective end-points (31 to 34) and of the distances (dp1, dp4) between each end-point (31 to 34) of one of these polygons (Pm, Pf) and the orthogonal projection (PP1 to PP4) of this end-point (31, 34), if it exists, onto the other polygon (Pf, Pm).

13. A process according to one of Claims 10 to 12, **characterised in that** the optimal execution option is determined by optimising the value of an execution score NEX of formula NEX=f(D(Pm, Pf), NACC(Pm), NACC(Pf)), where D(Pm, Pf) is the calculated distance between the mother polygon (Pm) and the daughter polygon (Pf), NACC(Pm) and NACC(Pf) are accessibility scores of the mother polygon (Pm) and of the daughter polygon (Pf), respectively, which have been calculated in such a way as to be minimal for the polygons that are of least depth and the most accessible, and f is a multipolynomial function.

14. A process according to one of Claims 1 to 8, **characterised in that** the servicing operation includes a plurality of steps.

15. A process according to one of Claims 1 to 8, **characterised in that** when the servicing operation consists in realising a step of cutting (17) of a track, called the daughter track (10), of conductive material forming an equipotential region, called the daughter equipotential region of the electrical configuration, and a step of deposition of a track of conductive material (18) between a track, called the mother track (20), of conductive material forming an equipotential region, called the mother equipotential region, of the electrical configuration and a residual portion (16a) of the daughter track (10) between the cutting (17) and a first shunt node (11) encountered in a predetermined direction downstream of the cutting (17),
- in the course of the retrieval step at least all the accessible polygons of each mother track (20) and daughter track (10) are retrieved,
- an execution score is calculated and is assigned to each option for execution of the deposition step by considering all the accessible polygons of the mother track (20) and of the daughter track (10),
- an execution score is calculated and is assigned to each option for execution of the cutting step,
- the best compromise between the cutting step and the deposition step is determined automatically by determining, for each option for execution of the cutting step, the optimal option (DEPOPT) for execution of the deposition step corresponding to this option for execution of the cutting step by considering, for the options for execution of the deposition step, solely the accessible polygons of the portion (16b) of the upstream reduced branch of the daughter track (10) extending between the cutting (17) and the topological shunt node (11).

16. A facility comprising:
- means (2) for receiving an integrated circuit (3) comprising several physical layers defining an electrical configuration having several electrical functional elements, and
- means (4) for servicing on at least one side, called the servicing side (5), of an integrated circuit (3) placed on the receiving means (2), these servicing means (4) being suitable to enable a predetermined servicing operation to be performed comprising at least one step applied in a localised zone which is accessible from the servicing side to at least one element of the electrical configuration,
- means, called the means for retrieval of accessible polygons, for calculating, in accordance with accessibility criteria and on the basis of, on the one hand, topographic-description data identifying, in each layer of the circuit (3), polygons each formed from a characteristic material of the circuit (3), and, on the other hand, data that are representative of the electrical configuration, data identifying, for at least each element of the electrical configuration to which at least one step of the servicing operation has to be applied, the various polygons, called the accessible polygons, defining this element in each layer of the circuit (3), and on which the servicing means (4) can be positioned and can perform at least one step of the servicing operation from the servicing side (5),
- means for determining, for each step of the servicing operation, various options for execution of this step, corresponding respectively to each of the various accessible polygons, called the possible initial polygons, on which this step can be executed, all the various execution options producing results that are equivalent from the point of view of the electrical configuration, and for calculating and assigning a score to each execution option as a function of:
. the depth of each possible initial polygon of this execution option, represented by the distance separating the layer including this polygon from the servicing side (5), and
. accessibility parameters of each possible initial polygon of this execution option,
- means for automatically determining the optimal execution option to be used for executing each step of the servicing operation by a numerical optimisation calculation using the scores assigned to the various options for execution of each step of the servicing operation,
**characterised in that** said means for retrieval of accessible polygons are suitable to calculate and generate, for each element, data identifying at least one series of accessible polygons that satisfy the following conditions:
- they have a surface, called the reduced accessible surface, corresponding to a surface which is not masked from the servicing side by a higher layer of material of the same kind, and the dimension of which in each direction between two higher elements is decreased by a value αi which depends on the depth of the layer of the polygon and on the nature of the servicing means intended to be used on this element,
- the dimension in each direction of the reduced accessible surface is greater than a minimal threshold value β,
- said reduced accessible surface is remote from all the polygons of material of the same kind pertaining to another element by a distance greater than a predetermined value λ.

17. A facility according to Claim 16, **characterised in that** it is suitable to implement a process according to one of Claims 1 to 15.
